(19) Europäisches Patentamt / European Patent Office / Office européen des brevets

(11) **EP 1 527 521 B1**

(12) **FASCICULE DE BREVET EUROPEEN**

(45) Date de publication et mention de la délivrance du brevet:
**21.03.2018 Bulletin 2018/12**

(21) Numéro de dépôt: **03755610.7**

(22) Date de dépôt: **16.07.2003**

(51) Int Cl.:
***H03M 7/30*** *(2006.01)*

(86) Numéro de dépôt international:
**PCT/FR2003/002246**

(87) Numéro de publication internationale:
**WO 2004/012340 (05.02.2004 Gazette 2004/06)**

(54) **DISPOSITIF ET PROCEDE DE DECODAGE ROBUSTE DE CODES ARITHMETIQUES**

VORRICHTUNG UND VERFAHREN ZUR ROBUSTEN DEKODIERUNG ARITHMETISCHER KODES

DEVICE AND METHOD FOR ROBUST DECODING OF ARITHMETIC CODES

(84) Etats contractants désignés:
**AT BE BG CH CY CZ DE DK EE ES FI FR GB GR HU IE IT LI LU MC NL PT RO SE SI SK TR**

(30) Priorité: **22.07.2002 FR 0209287**
**18.03.2003 FR 0303288**

(43) Date de publication de la demande:
**04.05.2005 Bulletin 2005/18**

(73) Titulaire: **Thomson Licensing**
**92130 Issy-les-Moulineaux (FR)**

(72) Inventeurs:
• **GUIONNET, Thomas**
**F-35000 Rennes (FR)**
• **GUILLEMOT, Christine**
**F-35135 Chantepie (FR)**

(74) Mandataire: **Huchet, Anne et al**
**TECHNICOLOR**
**1-5, rue Jeanne d'Arc**
**92130 Issy-les-Moulineaux (FR)**

(56) Documents cités:
• MURAD A H ET AL: "Joint source-channel decoding of variable-length encoded sources" INFORMATION THEORY WORKSHOP, XX, XX, 22 juin 1998 (1998-06-22), pages 94-95, XP002143123

• MURAD A H ET AL: "Robust transmission of variable-length encoded sources" WIRELESS COMMUNICATIONS AND NETWORKING CONFERENCE, 1999. WCNC. 1999 IEEE NEW ORLEANS, LA, USA 21-24 SEPT. 1999, PISCATAWAY, NJ, USA,IEEE, US, 21 septembre 1999 (1999-09-21), pages 968-972, XP010353592 ISBN: 0-7803-5668-3

• GUYADER A ET AL: "Joint source-channel turbo decoding of entropy-coded sources" IEEE JOURNAL ON SELECTED AREAS IN COMMUNICATIONS, SEPT. 2001, IEEE, USA, vol. 19, no. 9, pages 1680-1696, XP002267570 ISSN: 0733-8716

• DEMIR N ET AL: "Joint source/channel coding for variable length codes" DATA COMPRESSION CONFERENCE, PROCEEDINGS. DCC, IEEE COMPUTER SOCIETY PRESS, LOS ALAMITOS, CA, US, 30 mars 1998 (1998-03-30), pages 139-148, XP002143231

• FABRE E ET AL: "Joint source-channel turbo decoding of VLC-coded Markov sources" 2001 IEEE INTERNATIONAL CONFERENCE ON ACOUSTICS, SPEECH, AND SIGNAL PROCESSING. PROCEEDINGS (CAT. NO.01CH37221), 2001 IEEE INTERNATIONAL CONFERENCE ON ACOUSTICS, SPEECH, AND SIGNAL PROCESSING. PROCEEDINGS, SALT LAKE CITY, UT, USA, 7-11 MAY 2001, pages 2657-2660 vol.4, XP002267571 2001, Piscataway, NJ, USA, IEEE, USA ISBN: 0-7803-7041-4

• PARK M S ET AL: "DECODING ENTROPY-CODED SYMBOLS OVER NOISY CHANNELS BY MAP SEQUENCE ESTIMATION FOR ASYNCHRONOUS HMMS" PROCEEDINGS OF THE ANNUAL PRINCETON CONFERENCE ON INFORMATION SCIENCES AND SYSTEMS, XX, XX, 18 mars 1998 (1998-03-18), pages 477-482, XP000933543

**EP 1 527 521 B1**

**Description**

L'invention concerne la compression/décompression de données numériques, notamment pour des signaux multimédia (audio, image, vidéo, parole), et la transmission robuste de ces données sur des réseaux bruités, tels que des réseaux sans fils, des communications mobiles.

Pour réduire le débit de transmission des données numériques, on les comprime, en cherchant à s'approcher du maximum théorique que les spécialistes appellent "l'entropie du signal". Pour cela, on utilise souvent des codes statistiques aussi appelés codes à longueurs variables, par exemple les codes de Huffman. Ces codes ont néanmoins l'inconvénient d'être très sensibles aux erreurs de transmission. L'inversion de un bit peut conduire à une désynchronisation du décodeur, qui a pour conséquence un décodage erroné de toutes les données qui suivent la position du bit erroné.

Les solutions actuelles de compression, transmission et décompression de signaux multimédia sur réseau, sur lesquelles on reviendra, se fondent sur l'hypothèse qu'une certaine qualité de service du transport des données est garantie. En d'autres termes, elles supposent que les couches de transport et de liaison, en s'appuyant sur l'utilisation de codes correcteurs, vontpermettre d'atteindre un taux d'erreur résiduel quasi nul (c' est-à-dire vu par l'application de compression et de décompression). Mais cette hypothèse de taux d'erreur résiduel quasi nul n'est plus vraie lorsque les caractéristiques des canaux varient dans le temps (canaux non stationnaires), notamment dans les réseaux sans fil et mobiles, et pour une complexité du code de canal réaliste. En outre, l'ajout de redondance par codes correcteurs d'erreurs conduit à réduire le débit utile.

Le document de Fabre et al intitulé « Joint source-channel turbo decoding of VLC-coded Markovsources » , 2001 IEEE INTERNATIONAL CONFERENCE ON ACOUSTICS, SPEECH, AND SIGNAL PROCESSING. PROCEEDINGS (CAT. NO.01CH37221), 2001 IEEE INTERNATIONAL CONFERENCE ON ACOUSTICS, SPEECH, AND SIGNAL PROCESSING. PROCEEDINGS, SALT LAKE CITY, UT, USA, 7-11 MAY 2001, pages 2657-2660 vol.4, XP002267571, 2001, Piscataway, NJ, USA, IEEE, USA, ISBN: 0-7803-7041-4 décrit une méthode itérative de décodage conjoint source-canal inspirée des codes turbo dans laquelle les trois modèles de la chaine de codage, i.e. un modèle de la source de symboles, un modèle du codeur de la source et un modèle du codeur de canal, sont utilisés en alternance.

Le besoin se fait donc sentir de nouvelles solutions de codage/décodage.

La présente invention vient proposer des avancées en ce sens.

A cet effet, l'invention concerne un procédé de décodage, dans un décodeur arithmétique ou quasi-arithmétique, d'éléments binaires reçus d'un canal en des symboles x-aires comprenant les étapes suivantes:

- recevoir dudit canal un flux de N seconds éléments binaires Yi correspondants à N premiers éléments binaires Ui transmis, par l'intermédiaire dudit canal, d'un codeur arithmétique ou quasi-arithmétique vers ledit décodeur avec i compris entre 1 et N, ledit codeur codant une source de symboles;
- décoder lesdits N seconds éléments binaires Yi en un flux de K symboles x-aires Sj avec j compris entre 1 et K.

Avantageusement, l'étape de décodage comprend :

a. calculer des probabilités d'aboutir dans des états produits connaissant des bits du flux de seconds éléments binaires Yi, à partir d'un modèle dudit canal, d'un modèle de ladite source et d'un modèle produit définissant une correspondance entre lesdits symboles x-aires Sj et lesdits premiers éléments binaires Ui, à partir d'états produits dans un diagramme d'états "produit", un état produit comprenant un état source et un état d'un modèle dudit codeur ou dudit décodeur arithmétique ou quasi-arithmétique, et
b. déterminer le flux de symboles x-aires le plus probable à partir des probabilités calculées à l'étape a.

L'invention concerne également un dispositif de décodage arithmétique ou quasi-arithmétique correspondant au procédé.

D'autres caractéristiques et avantages de l'invention apparaîtront à l'examen de la description détaillée ci-après, et des dessins annexés, sur lesquels :

- la figure 1 illustre un ensemble comprenant un codeur et un décodeur selon l'invention,
- la figure 2 est une vue générale du procédé de codage implémentable dans un codeur selon l'invention,
- la figure 3 est un diagramme formant vue générale du procédé de décodage implémentable dans un décodeur selon l'invention,
- les figures 4A, 4B et 4C illustrent trois représentations différentes d'un même modèle dit "source" établissant une correspondance entre les symboles de la source et des séquences de bits,
- les figures 5A et 5B illustrent deux représentations différentes d'une même correspondance entre des séquences de symboles et des séquences de bits, basées sur le modèle dit "source" des figures 4A et 4B,

- la table 1 illustre une représentation sous forme de table d'un modèle dit "codeur",
- la table 2 illustre une représentation sous forme de table d'un modèle dit "décodeur",
- la figure 6A illustre une représentation sous forme de table d'un modèle dit "produit source-codeur"selon l'invention,
- la figure 6B illustre une représentation sous forme de treillis du modèle dit "produit source-codeur" de la figure 6A selon l'invention,
- les figures 7A et 7B illustrent deux représentations partielles sous forme de treillis du modèle dit "codeur" de la table 1,
- la figure 8 illustre une représentation généralisée d'un modèle dit "produit source-codeur"selon l'invention,
- la figure 9A illustre une représentation sous forme de table d'un modèle dit "produit source-décodeur"selon l'invention,
- la figure 9B illustre une représentation sous forme de treillis du modèle dit "produit source-décodeur" de la figure 9A selon l'invention,
- la figure 10 illustre une représentation généralisée d'un modèle dit "produit source-décodeur"selon l'invention,
- la figure 11 illustre le procédé de décodage dans une première réalisation selon l'invention,
- la figure 12 illustre le procédé de décodage dans une deuxième réalisation selon l'invention,
- la figure 13 illustre une représentation sous forme de treillis réalisée à partir du procédé de décodage de la figure 11 ou 12 ,
- la figure 14 illustre le procédé de décodage dans une troisième réalisation selon l'invention,
- la figure 15 illustre le procédé de décodage dans une quatrième réalisation selon l'invention.

En outre:

- l'annexe 1 contient des expressions mathématiques utilisées dans la présente description.

Les dessins et les annexes à la description comprennent, pour l'essentiel, des éléments de caractère certain. Ils pourront donc non seulement servir à mieux faire comprendre la description, mais aussi contribuer à la définition de l'invention, le cas échéant.

De manière générale, un système de compression de signaux multimédia (image, vidéo, audio, parole) fait appel à des codes statistiques aussi appelés codes à longueurs variables. Ceux-ci permettent d'obtenir des débits approchant ce que les spécialistes appellent "l'entropie du signal". Les codes les plus utilisés dans les systèmes existants (en particulier dans les standards) sont les codes de Huffman qui ont été décrits dans l'ouvrage suivant : D.A. Huffman : "A method for the construction of minimum redundancy codes", Proc. IRE, 40 (1951), p.1098-1101.

Plus récemment, on a vu un regain d'intérêt pour les codes arithmétiques en raison de leurs performances accrues en terme de compression. Ils permettent en effet de découpler le processus d'encodage du modèle supposé de la source. Ceci permet aisément d'utiliser des modèles statistiques d'ordre supérieur. Ces codes arithmétiques ont été décrits dans des ouvrages tels que

[1]- J.J. Rissanen "Generalized kraft inequality and arithmetic", IBM J.Res. Develop., 20:198-203, Mai 1976
[2]- J.J. Rissanen, "Arithmetic Coding as number representations", Acta Polytech. Scand. Math., 31:44-51, Décembre 1979

ainsi que dans des brevets américains US 4 286 256, US 4 467 317, US 4 652 856.

Jusque récemment, la conception des systèmes de compression se faisait en supposant une qualité de service transport garantie. On supposait en effet que les couches inférieures du modèle OSI incorporent des codes correcteurs d'erreurs garantissant un taux d'erreur résiduel vu de l'application quasi-nul.

Les codes à longueurs variables pouvaient donc être largement utilisés malgré leur forte sensibilité au bruit de transmission. Cette hypothèse de taux d'erreur résiduel quasi nul n'est plus vraie dans les réseaux sans fil et mobiles, dont les caractéristiques des canaux varient dans le temps (canaux non stationnaires). Ce taux d'erreur résiduel vu par le décodeur des signaux de source est souvent loin d'être négligeable. Toute erreur dans le train binaire peut engendrer une dé-synchronisation du décodeur et donc une propagation des erreurs sur la suite des informations décodées.

Pour pallier ce problème de propagation, les standards de premières générations (H.261, H.263, MPEG-1, MPEG-2) ont incorporé dans la syntaxe du train binaire transmis des marqueurs de synchronisation. Ce sont des mots de code longs (16 ou 22 bits constitués d'une suite de 15 ou 21 bits à '1' suivis d'un '0') non émulables par des erreurs se produisant sur les autres mots de code et qui peuvent donc être reconnus par le décodeur avec une probabilité proche de '1'.

Cela conduit à structurer le train binaire en paquets délimités par ces marqueurs de synchronisation. Cela permet de confiner la propagation des erreurs au sein du paquet.

Cependant si une erreur intervient en début de paquet la suite du paquet peut être perdue. En outre, la périodicité de ces marqueurs de synchronisation doit être restreinte pour éviter une perte trop grande en efficacité de compression.

Les nouveaux standards (H.263+ et MPEG-4) ont alors fait appel à des codes à longueurs variables réversibles (RVLC). La particularité de ces codes est qu'ils peuvent être décodés du premier vers le dernier bit d'un paquet, et, à l'inverse, du dernier vers le premier bit du paquet.

Si une erreur s'est produite en milieu de paquet, cette symétrie du code permet de confiner la propagation des erreurs sur un segment en milieu de paquet au lieu de la propager jusqu'à la fin du paquet délimité par un marqueur de synchronisation. Cependant, la symétrie du code engendre une perte en efficacité de compression par rapport à un code de Huffman de l'ordre de 10 %. En outre les codes à longueurs variables réversibles n'évitent pas complètement le problème de propagation des erreurs : si une erreur se produit en début et en fin de paquet, tout lé paquet risque d'être erroné.

La conception de procédés de codage/décodage robustes au bruit de transmission et basés sur une famille de codes performants en compression (i.e., qui permettent d'approcher l'entropie de la source), constitue un enjeu important, notamment pour les futurs systèmes de communication multimédia (image, vidéo, audio, parole) mobiles. Pour ces systèmes, de nouveaux standards sont à l'étude à la fois au sein de l'ITU (International Telecommunication Union) et de l'ISO (International Standard Organization).

Bien que les standards occupent une place prépondérante dans le secteur des télécommunications, une telle famille de codes peut aussi trouver des applications sur des marchés de niche faisant appel à des solutions propriétaires.

L'invention décrite concerne notamment un dispositif codeur/décodeur pour une famille de codes largement utilisés dans les systèmes de compression comme des codes de type arithmétique comprenant les codes arithmétiques et les codes quasi-arithmétiques.

Les principes du codage arithmétique et quasi-arithmétique sont développés ci-après. Ils sont développés plus en détail dans l'ouvrage [2] et les ouvrages suivants

[3]-I.H. Witten, R. M. Neal and J. G. Cleary. Arithmetic coding for data compression. Communications of the ACM, 30(6):520-540, Juin 1987,

[4] P. G. Howard and J. S. Vitter, Image and Text Compression, pages 85-112. Kluwer Academic Publisher, 1992.

Dans le reste de la description, l'utilisation du mot "séquence" désigne un flux ou une suite d'éléments. Par exemple, une séquence de bits, respectivement de symboles désignera un flux ou une suite de bits, respectivement de symboles.

Le principe du codage consiste de façon générale à procéder aux étapes suivantes :

soit $A = A_1 ... A_L$, une séquence de symboles de source quantifiés qui prennent leur valeur dans un alphabet fini A composé de $M = 2^q$ symboles, $A=\{a_1 ... a_M\}$. Cet alphabet a une distribution stationnaire qui indique pour chaque symbole une probabilité stationnaire associée. Cette séquence de symboles M-aires (appelée également source A) est convertie en une séquence de symboles x-aires (avec x≤M). Dans le cas où cette séquence de symboles *M*-aires est convertie en une séquence de symboles binaires $S=S_1...S_K$, (appelée également source S), K est définit par K=qxL. Les variables M et x définissent des entiers à partir de 2. Ainsi, dans l'exemple, x = 2 et M=4.

A titre d'exemple uniquement dans le reste de la description, et pour des raisons de simplification, on considérera que x=2. Cette conversion utilise un modèle de source décrit ci-après comprenant une correspondance entre la source M-aire A et la source binaire *S*. Cette séquence de symboles binaires S est convertie à son tour en une séquence de premiers éléments binaires d'information $U=U_1 ...U_N$, par l'intermédiaire d'un codeur quasi-arithmétique de précision T. La longueur N de ce train binaire est une variable aléatoire, fonction de S, la séquence de symboles binaires, elle-même fonction de A, la séquence de symboles *M*-aires. Le train de premiers éléments binaires U est transmis, à titre d'exemple uniquement, sur un canal sans mémoire. Ce train de premiers éléments binaires U est reçu comme un train de seconds éléments binaires Y en raison d'erreurs introduites lors de la transmission par le canal de communication. Les couches inférieures du système de communication permettent en effet de déterminer au moins les propriétés courantes lc du canal de communication, par exemple le taux d'erreurs introduites par le canal dans les bits communiqués, des mesures de confiance sur des bits reçus. Ces dernières mesures permettent d'estimer des probabilités de recevoir un second élément binaire connaissant un premier élément binaire communiqué sur le canal. Ces probabilités sont estimées comme indiqué en annexe (équation 21 avec l'indice i étant un entier) à partir d'une des propriétés courantes lc du canal : p, la probabilité d'erreur sur le canal.

Le principe du décodage consiste à estimer la suite de symboles A, connaissant les seconds éléments binaires appelés également par la suite "observations y". Dans le reste de la description, les lettres majuscules seront utilisées pour dénoter les variables aléatoires, et les minuscules pour les réalisations, ou observations de ces variables. Pour noter une suite de variables successives, la notation $X_u^v =\{X_u, X_{u+1}...X_v\}$.

Le principe de codage/décodage peut également être directement appliqué à une source correspondant non pas à des symboles M-aires (A) avec M>2 mais à des symboles binaires (*S*) avec M=2. Dans la suite de la description, un symbole x-aire, respectivement un symbole M-aire, comprend notamment le cas du symbole binaire (x=2, respectivement M=2) et le cas du symbole pour lequel x>2, respectivement M>2.

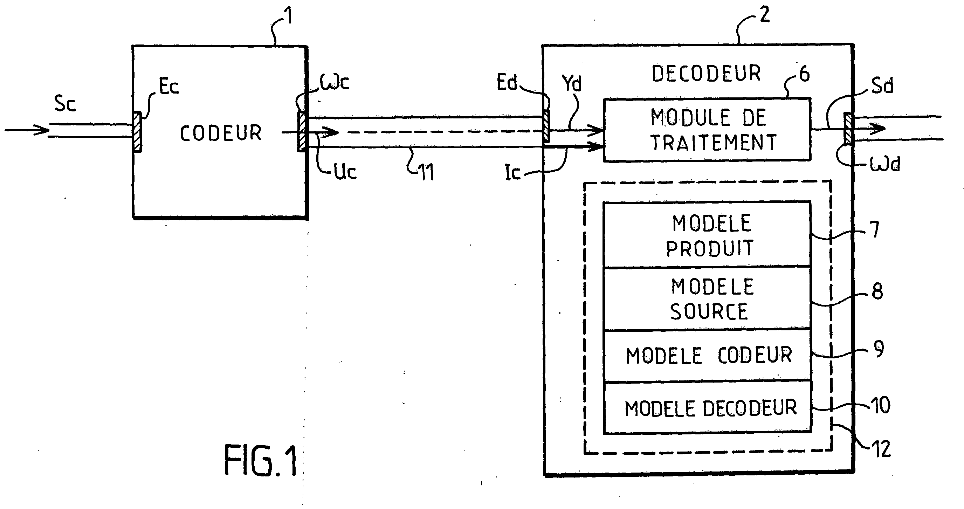

La figure 1 illustre un exemple d'ensemble de codeur 1 et de décodeur 2. Le codeur et le décodeur ont respectivement une entrée Ec, Ed et une sortie Wc, Wd. Lors du codage, un flux de symboles x-aires à coder est reçu en entrée du codeur en Ec. Le codeur transmet en sortie Wc un flux de premiers éléments binaires, appelé premier flux de bits Uc, généré par codage du flux de symboles x-aires, par exemple sous forme comprimée. Ce premier flux de bits Uc est envoyé, par l'intermédiaire d'un canal 11, à l'entrée Ed du décodeur 2. Le canal, ayant pu erroner le premier flux de bit (par exemple inverser certains bits du premier flux), transmet un flux de seconds éléments binaires, appelé second flux de bits Yd, à l'entrée du décodeur 2. Selon l'invention, un module de traitement 6 reçoit et traite ce second flux de bits ainsi que les propriétés Ic du canal, communiquées par le canal, pour obtenir en sortie Wd du décodeur, un flux de symboles Sd. Un module de traitement 6 est propre à travailler avec le module de modèles 12. Ce module de modèles comprenant

- un modèle de source 8 permettant de définir des probabilités pour des symboles x-aires associés à des transitions entre états sources dans un diagramme d'états source décrit ci-après,
- un modèle dit "produit" 7 permettant de définir une correspondance entre les symboles x-aires et de premiers éléments binaires, en fonction d'états dans un diagramme d'états "produit", un état produit étant fonction d'un état source et d'un état d'un modèle de transfert.

Le modèle produit 7 est établi à partir du modèle source 8 et d'un modèle de transfert 9 ou 10. Le modèle produit peut être construit dynamiquement à partir du modèle de source et des modèles de transfert 9 ou 10. Dans une autre réalisation possible, le modèle produit peut être implémenté dans le module de modèles sans être construit dynamiquement. Le modèle de transfert comprend un modèle de codage 9 ou un modèle de décodage 10. Ce modèle de transfert permet d'établir une correspondance entre des symboles binaires et de premiers éléments binaires, en fonction de probabilités associées à des symboles binaires.

Il est également possible de partir d'une séquence de symboles M-aire pouvant être au préalable transformée en une séquence de symboles x-aires avant d'être compressée en utilisant le modèle source.

Dans une réalisation possible, ces modèles peuvent être pré-calculés et mis en mémoire dans un module externe au module de modèle du décodeur. Ils peuvent également être utilisés à distance, par exemple en se servant d'un réseau local de type Ethernet ou un réseau plus étendu de type internet.

Le module de traitement 6 est adapté pour calculer des probabilités de symboles x-aires, connaissant les bits du flux de seconds éléments binaires, à partir des propriétés Ic du canal, du modèle source et du modèle produit. Le module de traitement 6 est adapté pour reconstituer le flux de symboles x-aires le plus probable à partir de ces probabilités calculées et pour reconstituer le flux de symboles M-aires à partir du modèle source si un flux de symboles M-aires a été codé.

Le procédé découlant de ce dispositif selon l'invention est décrit dans le reste de la description et permettra, notamment, de mieux comprendre le fonctionnement d'un tel dispositif.

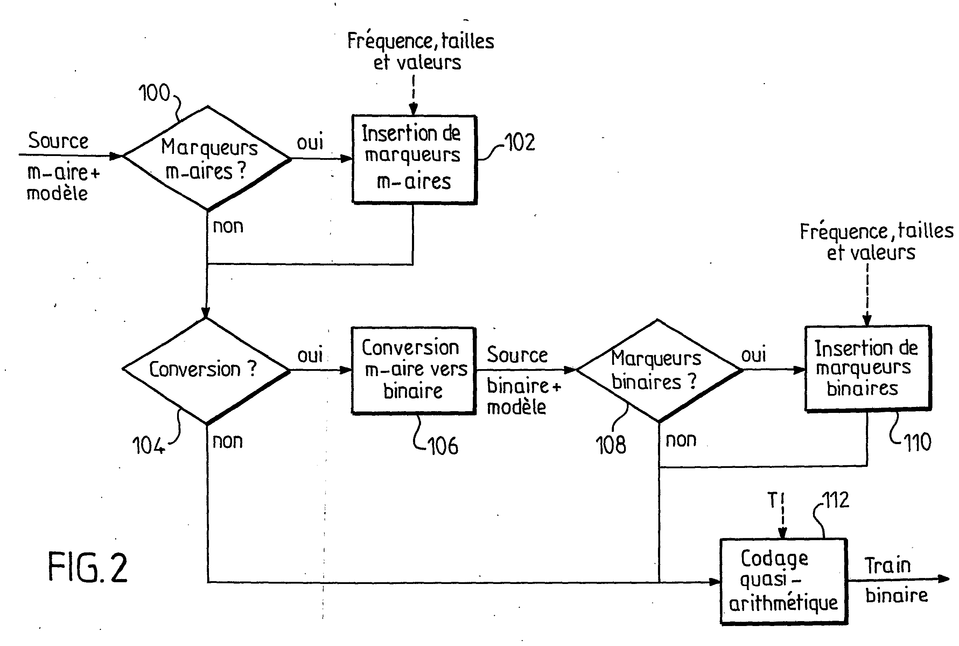

La figure 2 illustre un exemple de procédé de codage pouvant utiliser l'insertion de marqueurs de synchronisation. Ce procédé est implémenté dans un codeur recevant en entrée une source (M-aire), par exemple une séquence de données.

A l'étape 100, lorsque la séquence de données ne nécessite pas de marqueurs M-aires, le procédé continue à l'étape 104. Si, au contraire, des marqueurs M-aires doivent être insérés dans la séquence de données, la fréquence, la taille et la valeur de ces marqueurs sont fournies par le codeur pour effectuer l'insertion de ces marqueurs à l'étape 102.

A l'étape 104, il est vérifié si la séquence de données (comprenant ou non des marqueurs de synchronisation) nécessite une conversion M-aire/binaire. Si tel n'est pas le cas, la séquence de données est donc binaire et est soumise au codage arithmétique (quasi-arithmétique dans l'exemple de la figure) à l'étape 112. Sinon, la conversion M-aire/binaire de la séquence s'effectue à l'étape 106. A l'étape 108, si des marqueurs binaires doivent être insérés, la fréquence, la taille et la valeur de ces marqueurs sont fournies par le codeur pour effectuer l'insertion de ces marqueurs à l'étape 110.

A l'étape 112, la séquence de données M-aire ou binaire est soumise au codage quasi-arithmétique dont la complexité est contrôlée par le paramètre T. Si T est grand, le codage quasi-arithmétique devient identique à un codage arithmétique. Il en résulte une compression -maximale de la séquence de données binaire en un train de bits.

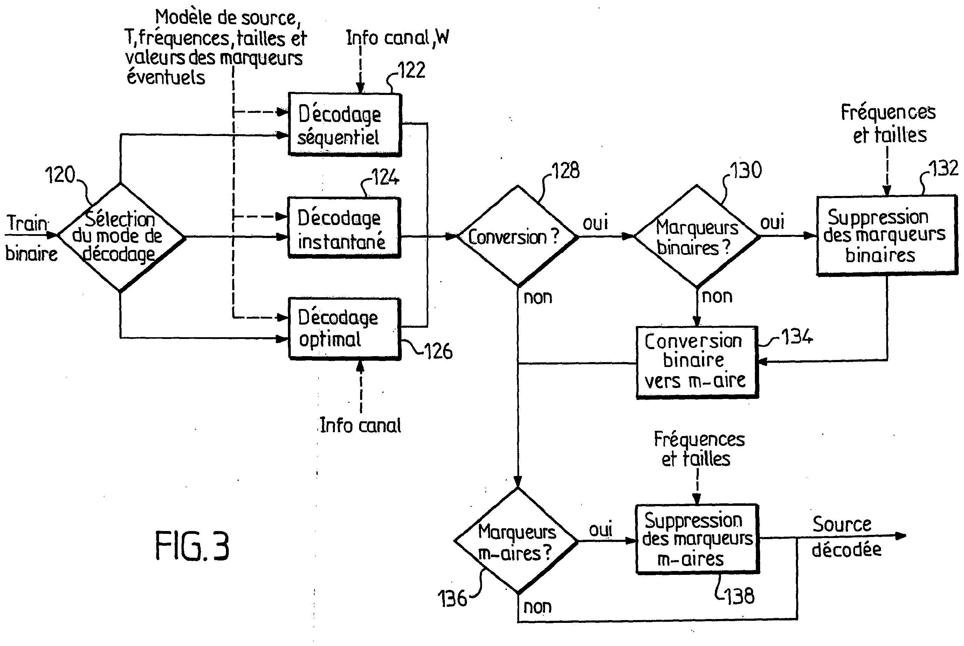

La figure 3 illustre un exemple de procédé de décodage prenant en compte les marqueurs de synchronisation insérés. Ce procédé est implémenté dans un décodeur recevant en entrée le train binaire et des informations concernant la source M-aire ou x-aire (notamment binaire), la fréquence, la taille et la valeur des marqueurs de synchronisation éventuels.

A l'étape 120, différents modes de décodage peuvent être sélectionnés :

- un décodage instantané à l'étape 124,

- un décodage séquentiel selon l'invention, qui est détaillé dans le reste de la description, à l'étape 122,
- un décodage optimal, qui est détaillé dans le reste de la description, selon l'invention à l'étape 126.

A l'étape 128, il est vérifié si la séquence de données obtenue après décodage nécessite une conversion binaire/M-aire.

Si tel est le cas, la séquence de données est donc binaire et à l'étape 130, il est vérifié si la séquence de données comprend des marqueurs binaires. Si tel est le cas, ces marqueurs sont supprimés à l'étape 132 en utilisant les informations sur leur fréquence et leur taille. Après l'étape 130 ou l'étape 132, la séquence de données est soumise à la conversion binaire/M-aire à l'étape 134.

Après l'étape 128 ou 134, il est vérifié si la séquence de données comprend des marqueurs M-aires à l'étape 136. Si tel n'est pas le cas, le décodage de la séquence de données (ou source) est terminé, sinon, les marqueurs sont supprimés à l'étape 138 pour obtenir la séquence de données (ou source).

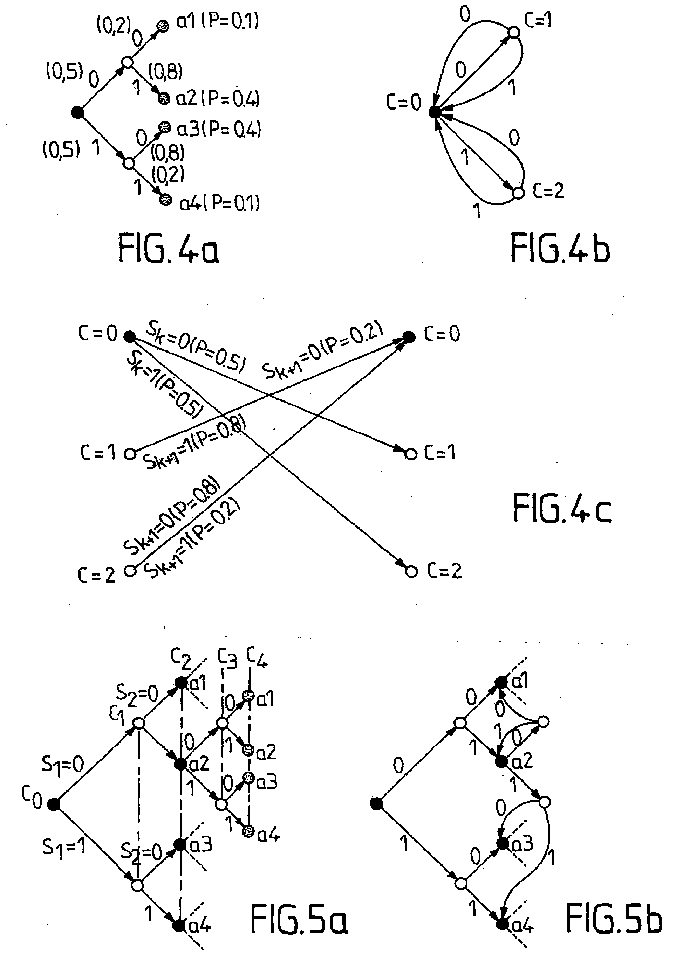

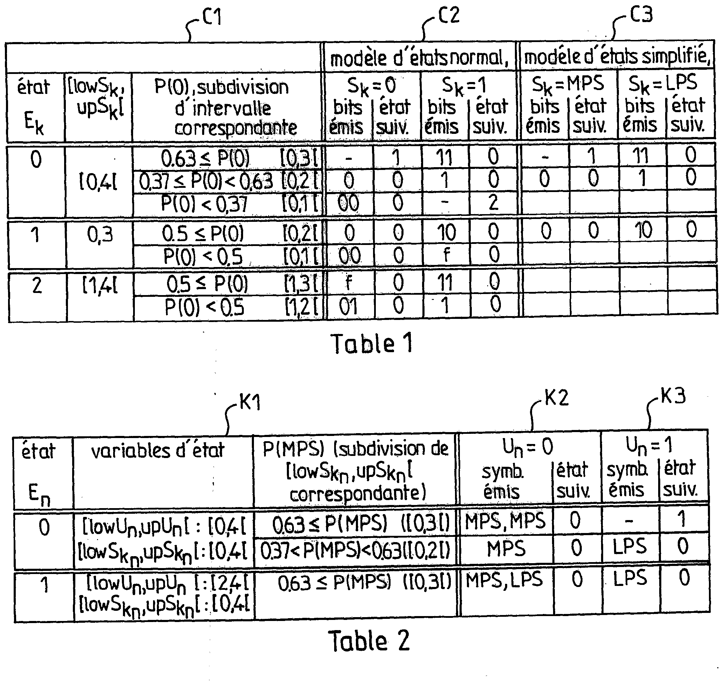

Les figures 4 à 5 illustrent des modèles de source pour la conversion M-aire/binaire et binaire/M-aire d'une séquence de données (ou source).

La figure 4A illustre la représentation binaire des 4 symboles d'une source 4-aire, c'est-à-dire une source prenant valeur dans un alphabet 4-aire. Ce modèle source peut être un arbre binaire de profondeur q, comme cela est montré sur la figure 4A pour q=2 et M=4. Dans une variante, cet arbre peut être représenté par une table de correspondance. Le noeud noir est appelé racine de l'arbre, les noeuds blancs sont les noeuds intermédiaires, les noeuds grisés sont appelés feuilles de l'arbre. Les probabilités P de chaque symbole M-aire correspondent aux probabilités stationnaires de la source. Les probabilités de transition (non représentées) sur les branches de cet arbre binaire sont calculées à partir des probabilités stationnaires.

La figure 4B représente l'automate permettant de convertir la séquence de symboles M-aires indépendants en une séquence de symboles binaires. Ce modèle de source peut également être représenté en figure 4B sous forme d'un automate à trois états : C = 0 pouvant être l'état initial, C=1 et C=2 les états intermédiaires. En variante, ce modèle de source peut être représenté en figure 4C sous forme d'un treillis avec les mêmes états : C=0 à gauche, l'état initial relié aux états intermédiaires C=1 et C=2 à droite, ces états intermédiaires, à gauche, étant reliés à l'état C=0 à droite. De plus, dans cet exemple, les probabilités de chaque symbole x-aire (ici, symbole binaire) sont indiquées sur les transitions correspondantes.

Pour un flux de données comprenant plusieurs symboles M-aires non indépendants, un modèle complet de la source est obtenu en connectant des modèles locaux successifs comme indiqué sur la figure 5A. Un modèle local correspond à un modèle de source pour un flux comprenant un symbole comme illustré sur la figure 4A. En référence aux figures 5, pour un flux de deux symboles M-aires dépendants, le modèle complet de la source consiste à identifier les feuilles du premier arbre binaire avec la racine de l'arbre suivant, racine représentée par un noeud noir sur les figures 5A et 5B. La figure 5A combine ainsi des arbres binaires entre-eux. En variante, la figure 5B combine un premier arbre binaire avec des automates correspondants prenant pour état initial et final les feuilles de l'arbre binaire. Cet automate permet de convertir une séquence de symboles M-aires dépendants en une séquence de symboles binaires.

D'après la figure 5A, les états $C_k$ définissent les noeuds possibles dans lesquels peut être l'automate après la production de k symboles binaires. Cet ensemble de noeud possible est symbolisé sur la figure par un trait mixte reliant les noeuds d'un même état k. La séquence $C_0,...,C_K$ est une chaîne de Markov et le flux de symboles binaires correspondant est fonction des transitions de cette chaîne. Les transitions appelées $S_k$ puisqu'elles engendrent l'émission des symboles binaires $S_k$, représentent l'ensemble des transitions possibles entre l'ensemble des états $C_{k-1}$ et l'ensemble des états $C_k$ du modèle source.

A partir de cet automate stochastique, le flux de symboles binaires peut être modélisé par un modèle de Markov caché.

Connaissant chaque probabilité stationnaire associée à chaque symbole binaire, chacune de ces probabilités correspondant à un des segments de l'intervalle unitaire [0,1[, le codage arithmétique permet, pour une séquence de symboles binaires, de déterminer l'intervalle de cette séquence. Ce dernier représente un segment de l'intervalle unitaire et sa borne inférieure est issue de la somme des probabilités des séquences de symboles correspondant aux sous-intervalles inférieurs. La largeur de cet intervalle est donnée par la probabilité de la séquence de symboles correspondant à cet intervalle. On appelle "intervalle courant", l'intervalle correspondant à une partie de la séquence et donc à l'état $C_k$ courant de cette partie de séquence, lors du calcul de l'intervalle ou sous-segment associé à la sous séquence correspondant à l'état $C_k$.

Des mises en oeuvre pratiques du codage arithmétique ont d'abord été introduites dans l'ouvrage [1], l'ouvrage suivant :

[5]- R. Pasco. Source coding algorithms for fast data compression. PhD thesis, Dept. of Electrical Engineering, Stanford Univ., Stanford Calif.,1976

et revisitées dans [2]. Un problème qui se pose lors de cette mise en oeuvre est la nécessité de disposer d'une grande précision numérique pour représenter des intervalles avec des nombres réels très petits. Cette difficulté peut être résolue en se basant sur la représentation binaire des nombres réels dans l'intervalle [0,1[, ce qui est décrit dans [3].Tout nombre appartenant à l'intervalle [0,0.5[ a son premier bit égal à 0,alors que tout nombre appartenant à l'intervalle [0.5,1[ a son premier bit égal à 1. Par conséquent, pendant le processus de codage, dés que l'intervalle courant est entièrement contenu dans [0,0.5[ ou [0.5,1[, le bit correspondant est émis et la taille de l'intervalle est doublée. Un traitement spécifique est nécessaire pour les intervalles qui chevauchent ½. Si l'intervalle courant chevauche ½ et est entièrement contenu dans [0.25,0.75[, il ne peut pas être identifié par un bit unique. Sa taille est tout de même doublée, sans émettre de bit, et le nombre de fois (n) où cette opération est effectuée avant d'émettre un bit est mémorisée, n est le nombre de remises à l'échelle effectuées depuis la dernière émission d'un bit. Lorsqu'un intervalle pour lequel un bit $U_i = u_i$ est émis est atteint, alors ce bit est suivi par la séquence de n fois le bit de valeur opposée.

L'utilisation de cette technique garantit que l'intervalle courant satisfait en permanence *low* < 0.25 < 0.5 ≤ *high* ou *low* < 0.5 < 0.75 ≤ *high*, avec *low* et *high* les bornes inférieures et supérieures de l'intervalle courant respectivement.

Le principe du codage arithmétique peut se modéliser par un automate stochastique dont les états E sont définis par trois variables : low, up et $n_{scl}$ le nombre de remises à l'échelle. L'inconvénient de ce codage est qu'il peut exister un très grand nombre d'états si la distribution stationnaire de la source n'est pas connue a priori ou si le flux comprend un nombre de symboles x-aires important. Le codage quasi-arithmétique, également appelé codage arithmétique à précision réduite, permet de réduire le nombre d'états possibles sans perte importante en efficacité de compression, comme décrit dans l'ouvrage [4]. Pour effectuer le codage quasi-arithmétique, l'intervalle réel [0,1[ est remplacé par l'intervalle entier [0,T[. L'entier T permet de contrôler le compromis entre la complexité et l'efficacité de compression : si T est grand, alors les subdivisions de l'intervalle représenteront précisément la distribution de la source. Par contre, si T est petit (proche de 1), toutes les subdivisions possibles de l'intervalle pourront être pré-calculées, ces subdivisions représenteront seulement une approximation de la distribution de la source.

Comme présenté dans la table 1, toutes les transitions entre états et les émissions de bits correspondantes peuvent être pré-calculées. Les opérations arithmétiques sont alors remplacées par des lectures de table.

Une séquence $S_1^K$ de symboles binaires est convertie un flux de bits $U_1^N$ par un arbre binaire. Cet arbre peut être vu comme un automate ou un modèle codeur qui modélise la distribution du train binaire. Le codage d'un symbole détermine le choix d'un arc de l'arbre, auquel peut être associée l'émission de bits. Chaque noeud correspond à un état E du codeur arithmétique. Les transitions successives entre ces états suivent la distribution de la source $P(S_k|S_{k-1})$ pour une source de Markov d'ordre 1. Soit $E_k$ l'état de l'automate à chaque "instant symbole" k. Comme pour le codage arithmétique, l'état $E_k$ du codeur quasi-arithmétique est défini par trois variables: $lowS_k$, $upS_k$ et $nscl_k$. Les termes $lowS_k$ et $upS_k$ désignent les bornes de l'intervalle résultant des subdivisions successives de [0,T[ correspondant au codage de la séquence $S_1^K$. La quantité $nscl_k$ est remise à zéro chaque fois qu'un bit est émis et incrémentée chaque fois qu'une remise à l'échelle sans émission de bit est effectuée. Elle représente donc le nombre de remises à l'échelle effectuées depuis la dernière émission de bit. Quand un bit est émis, il est suivi par $nscl_k$ bits de valeur opposée.

Dans la mesure où il y a un nombre fini de subdivisions possibles de l'intervalle [0,T[, il doit être possible de pré-calculer tous les états du codeur quasi-arithmétique sans connaître la source à priori.

A titre d'exemple, la table 1 présente les états, les sorties et toutes les transitions possibles d'un codeur quasi-arithmétique de précision T=4 pour une source binaire. On s'intéressera dans un premier temps aux ensembles C1 et C2 de colonnes. La valeur de la variable nscl $_k$ n'est pas inclue dans le modèle d'état. Seuls les incréments de cette variable sont signalés par la lettre f dans le tableau comme dans l'ouvrage [4].

Le codeur a trois états possibles, correspondant à des subdivisions entières de l'intervalle [0,4[ prises par l'intervalle courant [$lowS_k$, $upS_k$[. On se reportera à l'ouvrage

[6] P. G. Howard and J. S. Vitter, Design and analysis of fast text compression based on quasi-arithmetic coding. In Data Compression Conference, pages 98-107, Snowbird, Utah,Mars-Avril 1993.

pour le choix de ces subdivisions. En fonction de la probabilité du symbole binaire d'entrée 0, l'intervalle courant [$lowS_k$, $upS_k$[ sera subdivisé en intervalles entiers. Suivant que, dans la colonne C2, le symbole binaire d'entrée est 0 ou 1, les subdivisions en intervalles entiers de l'intervalle courant [$lowS_k$, $upS_k$[ possibles conduisent à l'émission de bits indiquées ou à la remise à l'échelle appropriée avant de déterminer le prochain état de l'automate.

Dans le cas où les symboles en entrée sont des symboles binaires, le nombre d'états peut être encore réduit en identifiant les symboles binaires comme " moins probable" (LPS) et "plus probable" (MPS) dans la colonne C3, plutôt que 0 et 1 dans la colonne C2. Cela revient à considérer la probabilité de chaque symbole binaire plutôt que la valeur du symbole binaire, les MPS et LPS pouvant correspondre soit à un bit 0 soit à un bit 1. Le nombre de combinaisons possibles des probabilités de la source binaire est réduit. Cela permet de combiner certaines transitions et d'éliminer des états de l'automate.

La séquence $E_0...E_K$ d'états successifs du codeur quasi-arithmétique forme une chaîne de Markov et les sorties du codeur sont fonctions des transitions sur cette chaîne.

De la même manière que le codage quasi-arithmétique, le décodage peut se modéliser par un automate stochastique à nombre d'états $E_n$ fini comme présenté sur la table 2.

L'état d'un décodeur arithmétique est défini par deux intervalles : $[lowU_n,upU_n[$ et $[lowS_{Kn},upS_{Kn}[$. L'intervalle $[lowU_n,upU_n[$ correspond au segment de l'intervalle $[0,1[$ défini par la réception de la séquence de bits $U_1^n$. L'intervalle $[lowS_{Kn},upS_{Kn}[$ est le segment de l'intervalle $[0,1[$ obtenu quand la séquence de symboles $S_1^{Kn}$ a été décodée. Cet intervalle est mis à jour par cumul des probabilités de chaque symbole binaire décodé, de la même manière qu'au codage pour chaque symbole codé. Il reproduit le fonctionnement du codeur.

Un codeur et un décodeur arithmétique ne sont pas synchronisés. En effet, au codage, la réception d'un symbole n'entraîne pas nécessairement l'émission d'un bit. De même, au décodage, la lecture d'un bit n'entraîne pas nécessairement la production d'un symbole. Ainsi, si la lecture du premier symbole de la séquence à coder n'entraîne aucune émission de bit, il se peut qu'au décodage, la lecture du premier bit suffise à décoder le premier symbole. Les deux intervalles sont mis à l'échelle comme au codage afin d'éviter les problèmes de précision numérique.

Dans l'exemple de la table 2, un automate stochastique est défini pour une valeur de T = 4. La table présente les états, transitions et sorties d'un décodeur quasi-arithmétique pour une source binaire, avec T=4 et la simplification MPS/LPS.

Soit $E_n$ l'état de cet automate à "l'instant bit" n, c'est-à-dire à l'instant de traitement du bit reçu $U_n$. Cet état est défini par les valeurs des intervalles $[lowU_n,upU_n[$ et $[lowS_{Kn},upS_{Kn}[$. En fonction de la distribution stationnaire de la source (représentée, colonne K1, par la probabilité du symbole MPS le plus probable), l'intervalle courant $[lowS_{Kn},upS_{Kn}[$ sera subdivisé en intervalles entiers. Suivant que le bit d'entrée est $U_n = 0$ dans la colonne K2 ou $U_n =1$ dans la colonne K3, les subdivisions en intervalles entiers de l'intervalle courant $[lowS_{Kn},upS_{Kn}[$ possibles conduisent à l'émission de symboles MPS ou LPS indiquées ou à la remise à l'échelle appropriée avant de déterminer le prochain état de l'automate.

Un codeur, respectivement décodeur utilisant l'automate stochastique de la table 1, respectivement table 2, démarre à l'état $E_k =1$, respectivement $E_n =1$.

Différents modèles sont envisagés selon l'invention pour être utilisés dans des procédés de codage/décodage et pour être implémentés dans les codeurs/décodeurs correspondants. Ainsi, il est envisagé un modèle dit "produit" pouvant être un modèle résultant du produit des modèles source et codeur ou un modèle résultant du produit des modèles source et décodeur.

De manière générale, les états du modèle produit doivent rassembler les informations contenues dans les états de chacun des deux modèles (source et codeur ou source et décodeur). Dans le cas général, la taille de l'espace d'états du "modèle produit" ne peut pas être connue a priori. Elle peut être calculée à partir du modèle de source binaire et du paramètre T.

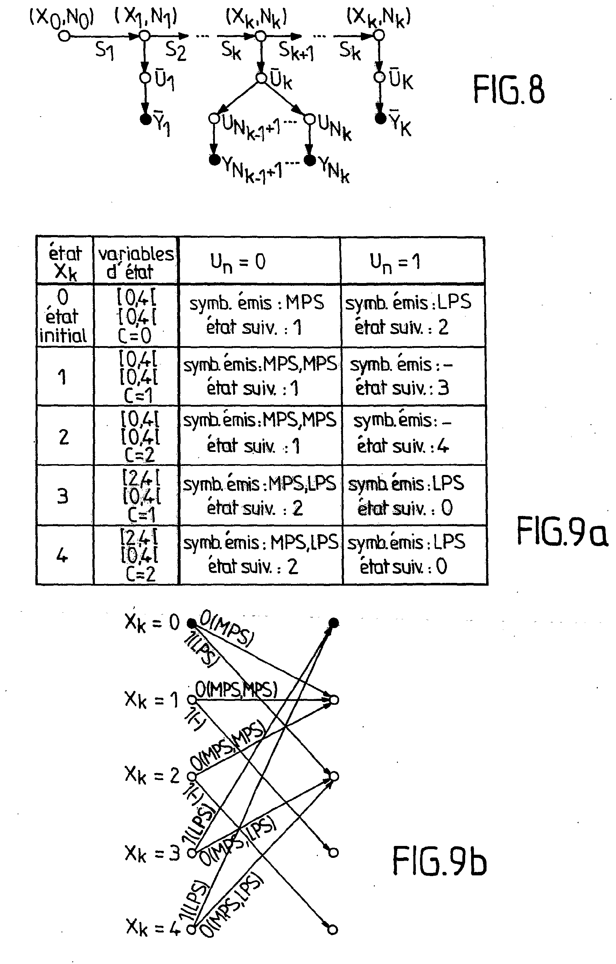

Pour un modèle produit source/codeur, comme le nombre de bits, dans chaque élément binaire, produit par chaque transition du modèle produit est aléatoire, la structure des dépendances entre la séquence de seconds éléments binaires et les états du modèle produit est aléatoire. Afin de "capturer"' cette structure de dépendances, le processus de Markov, représenté par les états $X_k$ du codeur selon le modèle produit, est augmenté d'un compteur $N_k$ pour obtenir la structure de dépendance suivante $(X,N)=(X_1,N_1)... (X_K,N_K)$. Chaque état $X_k$ du modèle produit est défini par l'état du modèle codeur, l'état du modèle source et le nombre de bits émis quand le k-ième symbole a été codé : $(X_k,N_k) = (lowS_k,upS_k,Ck,N_k)$. Cela conduit à la structure de dépendances décrite graphiquement par la figure 8. Suivant cette structure, une séquence de symboles binaires $S_1^K$ est convertie en une séquence de bits $U_1^{N_K}$, avec $N_K$ le nombre de bits émis quand K symboles ont été codés. Etant donné un état $X_{k-1}$ et un symbole d'entrée $S_k$, le modèle produit spécifie les bits $U_{Nk-1+1}$ à $U_{Nk}$ qui doivent être émis et l'état suivant $X_k$. Certaines transitions peuvent n'émettre aucun bit. Les probabilités des transitions entre $(X_k,N_k) = (lowS_k,upS_k,Ck,N_k)$ et l'état suivant dans le treillis $(X_{k+1},N_{k+1}) = (lowS_{k+1},upS_{k+1},C_{k+1},N_{k+1})$ sont données par le modèle de source binaire, $P(C_{k+1}|C_k)=P(S_{k+1}|C_k)$. Les seconds éléments binaires $Y_{Nk+1}$ à $Y_{Nk}$ sont obtenues à la sortie du canal de transmission lorsque les premiers éléments binaires $U_{Nk-1+1}$ à $U_{Nk}$ ont été émis. Ces seconds éléments binaires sont des observations sur les premiers éléments binaires.

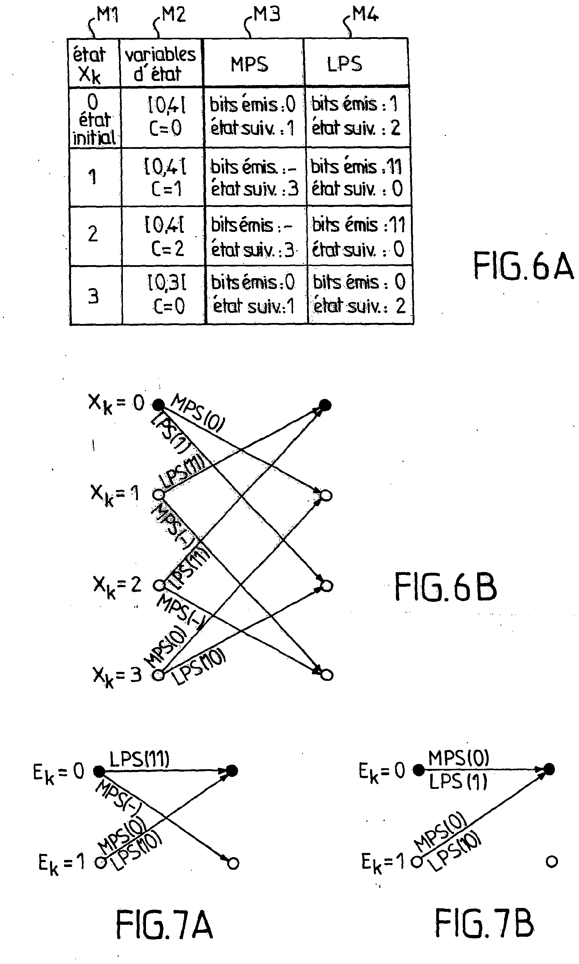

Un exemple de modèle produit issu des modèles source et codeur est présenté d'après les figures 6 et 7. L'exemple de modèle produit défini dans la table de la figure 6A est issu du produit du modèle source de la figure 4C et du modèle codeur de la table 1. En théorie, la taille de l'espace d'états résultant de ce produit est donnée par le produit des tailles des espaces d'états des deux modèles (source et codeur). Toutefois, des simplifications ont lieu, ce qui permet d'aboutir à un nombre d'états moins important.

Le modèle codeur arithmétique de la table 1 (T=4) utilisant le modèle d'état simplifié de la colonne C3 a été représenté sous forme de treillis aux figures 7A et 7B, la figure 7A correspondant à une probabilité $0.63 \leq P(MPS)$, la figure 7B correspondant à une probabilité $0.37 \leq P(MPS) \leq 0.63$. L'une ou l'autre de ces figures peut être utilisée suivant les probabilités de la source binaire. Les probabilités de la source binaire, résultant d'une conversion à partir d'une source M-aire, dépendent de l'état $C_k$ du modèle de cette source binaire. Les transitions du modèle produit source/codeur sont ainsi fonction de la distribution de la source. La table de la figure 6A est construite en fonction des états $C_k$ du

modèle de source de la figure 4C, de la probabilité des transitions $S_k$, les transitions $S_k=0$ et $S_k=1$ de la figure 4C étant modifiées en $S_k$=LPS et $S_k$=MPS, et des transitions du modèle de codeur représenté aux figures 7A et 7B en fonction de la probabilité de la source. La colonne M1 de la figure 6A ne contient que 4 états du modèle produit définis dans la colonne M2 par les variables d'états du modèle de source et du codeur correspondant. Le modèle de la source ayant 3 états et celui du codeur ayant 2 états, le modèle produit aura au maximum 6 états. En pratique, des simplifications ont lieu comme expliqué ci-après à l'aide des figures 7A et 7B. La figure 7A montre que pour un état $E_k=0$ du codeur, il est possible de continuer dans un état $E_k=1$ du codeur pour une probabilité du modèle de source 0,63<P(MPS). Par contre, la figure 7B indique qu'il n'est pas possible d'atteindre l'état $E_k=1$ du codeur à partir de l'état $E_k=0$.

Ainsi, dans le modèle produit de la figure 6A, aucun état du modèle produit $X_k=4$ et $X_k=5$ correspondant à des paires d'états du modèle source et codeur ($E_k=1$, $C_k=1$) et ($E_k=1$, $C_k=2$) n'existe pour la loi de probabilité telle 0,37<P(MPS) <0,63 du modèle de source. Les colonnes M3 et M4 indiquent, pour le symbole en entrée (MPS ou LPS), les bits émis et l'état suivant du modèle produit.

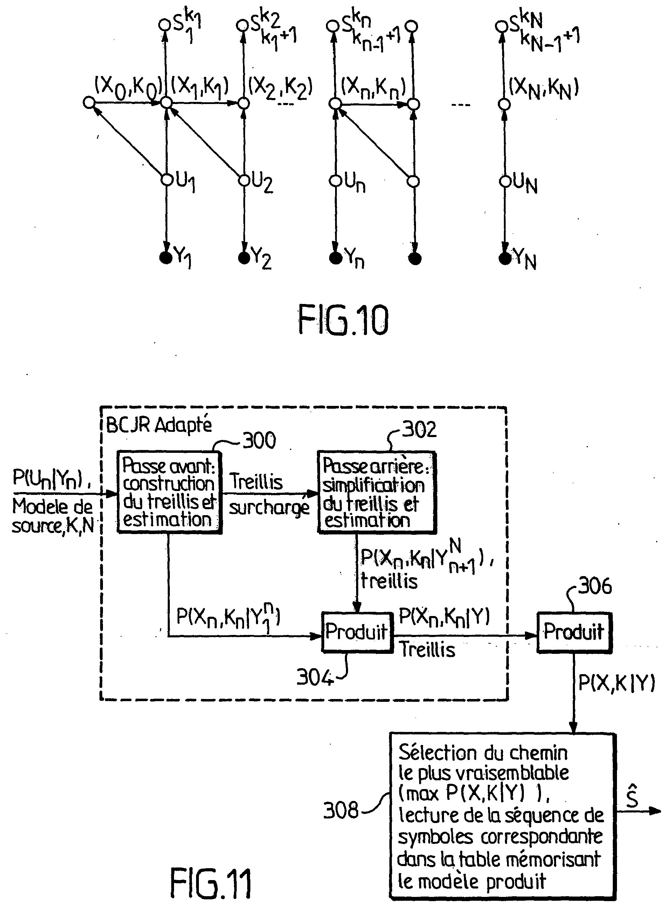

Pour un modèle source/décodeur selon la figure 9A ou 9B, les états de ce modèle produit doivent rassembler les informations des états des modèles de source et de décodeur. Un état $X_n$ de ce modèle produit est donc défini par $X_n$=(lowU$_n$,upU$_n$,lowS$_{Kn}$,upS$_{Kn}$,C$_{Kn}$), $K_n$ étant le nombre de symboles décodés quand n bits ont été reçus. Le nombre de symboles produits par chaque transition du modèle produit est aléatoire. Par conséquent, la structure des dépendances entre la séquence de second éléments binaires et les symboles décodés est aléatoire. La chaîne de Markov $X_1...x_N$ du modèle produit source/décodeur est augmentée par une variable compteur $K_n$ pour donner la chaîne de Markov (X,K)=($X_1$,$K_1$) ... ($X_N$,$K_N$) ce qui aboutit à la structure de dépendances illustrée à la figure 10. Suivant cette structure, une séquence de bits $U_1^N$ est convertie en une séquence de symboles $S_1^{KN}$, avec $K_N$ le nombre de symboles décodé quand N bits ont été reçus. Etant donnés un état $X_n$ et un bit d'entrée $U_{n+1}$, l'automate produit la séquence de symboles binaires $S_{Kn+1}^{Kn+1}$, et spécifie l'état suivant $X_{n+1}$. Les probabilités des transitions entre ($X_n$,$K_n$) et ($X_{n+1}$,$K_{n+1}$) dans le treillis dépendent du modèle de source binaire. Elles sont données par la formule en annexe (17). Comme pour le modèle source/codeur, des simplifications d'états de ce modèle sont possibles en fonction du modèle du décodeur et du modèle de source utilisé. Dans l'exemple de la figure 9A ou 9B, le modèle source utilisé est celui de la figure 4C et le modèle décodeur, celui de la table 2.

Les procédés de décodage robuste pour codes arithmétiques sont basés sur les modèles de dépendances décrits précédemment.

Une première réalisation du procédé de décodage robuste est illustrée par la figure 11.

Il est fait référence à l'annexe 1 pour ce qui concerne le développement mathématique associé.

Le décodeur reçoit en entrée le train de bits à décoder. Le modèle de source, la variable N représentant le nombre de bits reçus à décoder et la probabilité P($U_n$/$Y_n$) d'avoir émis un premier bit (ou premier élément binaire) $U_n$ sachant le second bit (ou second élément binaire) $Y_n$ observé sont des données que le décodeur a pour entrée, c'est à dire que, à titre d'exemple seulement, ces données peuvent être reçues en entrée avec le train de bits à décoder ou peuvent être lues dans une mémoire accessible par le décodeur. La probabilité P($U_n$/$Y_n$) peut être obtenue à partir des propriétés du canal.

Le critère du MAP (Maximum A Posteriori) correspond à l'estimation bayésienne optimale d'un processus X à partir des observations disponibles Y comme indiqué par l'équation (3) annexe 1. L'optimisation est effectuée pour toutes les "séquences" possibles. Dans cette première réalisation, ce critère est appliqué à l'estimation des états cachés des processus (X,N), qui peuvent être considérés comme des processus à horloge symbole, et des processus (X,K), qui peuvent être considérés comme des processus à horloge bit, étant données les séquences de bits observées. L'estimation peut être faite soit à horloge bit, soit à horloge symbole. Pour des raisons de simplicité de mise en oeuvre, l'estimation à horloge bit est privilégiée.

Dans ce cas, l'estimation de l'ensemble des états cachés (X,K)=($X_1$,$K_1$) ... ($X_N$,$K_N$) est équivalente à l'estimation de la séquence de symboles décodés correspondante S = $S_1$ ... $S_{Kn}$ ...$S_{KN}$, sachant les observations $Y_1^N$ à la sortie du canal. La meilleure séquence (X,K) peut être obtenue à partir des probabilités locales sur les paires ($X_n$,$K_n$) grâce à l'équation (4).

Le calcul de P($X_n$,$K_n$|Y) peut être effectué à partir de l'équation de décomposition (5) où $\alpha$ désigne un facteur de normalisation. Les dépendances de la chaîne de Markov permettent un calcul récursif des deux termes de la partie droite de cette équation, basé sur l'algorithme BCJR décrit dans l'ouvrage

[7] L.R. Bahl, J. Cocke, F. Jelinek, and J.Raviv. Optimal decoding of linear codes for minimizing symbol error rate. IEEE trans. on information theory, 02:284-287, March 1974.

Ainsi, à l'étape 300, le treillis est tout d'abord construit en utilisant le modèle source/décodeur de la figure 9A par exemple et les probabilités correspondantes sont calculées pour chaque transition du treillis. Ainsi, à partir du modèle produit, une passe avant permet la construction successive des états reliés par des transitions du diagramme d'états produit depuis un état d'origine à un état final. Chaque état définit un nombre attendu de symboles décodés pour un nombre donné de bits passés du flux de seconds éléments binaires depuis l'état d'origine. Durant cette même étape, la passe avant de l'algorithme BCJR permet de calculer le terme $P(X_n=x_n,K_n=k_n|Y_1^n)$ de la décomposition comme la somme sur l'ensemble des valeurs possibles de $x_{n-1},k_{n-1}$ du produit de trois probabilités conditionnelles (équation (6)): la probabilité récursive, la probabilité de transition entre les états $(x_{n-1}, k_{n-1})$ et $(x_n, k_n)$ donnée par le modèle produit (comme indiqué en équation 17 et représentant le produit des probabilités de transition $P(S_k|C_{k-1})$ précédemment dans le modèle source) et la probabilité d'avoir émis le bit $U_n$ (pouvant être 0 ou 1) déclenchant la transition entre les états $(x_{n-1}, k_{n-1})$ et $(x_n, k_n)$ sachant le second élément binaire $Y_n$. Cette dernière probabilité est obtenue à partir des propriétés du canal. Le calcul récursif est initialisé à l'état de départ (0,0) et permet de calculer $P(X_n,K_n|Y_1^n)$ pour tout état possible $(x_n,k_n)$ avec n=l...N de l'horloge bit. Ainsi, cette passe avant permet la construction du treillis du modèle produit et le calcul des probabilités $P(X_n,K_n|Y_1^n)$, successives et pour chaque instant n, d'aboutir dans un état donné $(X_n,K_n)$ connaissant des bits du flux de seconds éléments binaires $Y_1^n$.

A l'étape 302, la passe arrière permet d'obtenir le terme $P(Y_{n+1}^N|X_n=x_n,K_n=k_n)$ de la décomposition pour tout état possible $(x_n,k_n)$ à chaque instant bit n consécutivement de N à 1. Ce terme est calculé comme la somme du produit de trois probabilités conditionnelles (équation (7)): la probabilité récursive initialisée pour tous les "derniers états" possibles $(X_N,K_N)$, la probabilité de transition entre les états $(X_{n+1}, K_{n+1})$ et $(X_n, K_n)$ donnée par le modèle produit et la probabilité d'avoir émis le bit $U_{n+1}$ déclenchant la transition entre les états $(X_{n+1}, K_{n+1})$ et $(X_n, K_n)$ sachant le second élément binaire $Y_{n+1}$. Comme précédemment, cette dernière probabilité est obtenue à partir du modèle de canal. Ainsi, cette passe arrière permet de calculer les probabilités $P(Y_{n+1}^N|X_n=x_N,K_n=k_n)$, successives et pour chaque instant n de N à 1, d'observer des bits du flux de seconds éléments binaires $Y_1^n$ connaissant un état donné $(X_n,K_n)$.

Lorsque le nombre de symboles K est connu, une contrainte de terminaison peut être rajoutée lors de la passe arrière à l'étape 302. Ainsi, tous les chemins dans le treillis qui ne conduisent pas au bon nombre de symboles $K_N=K$ sont supprimés. Ainsi, la passe arrière comprend la suppression successive des états du diagramme d'états produit, depuis l'état final à l'état d'origine, pour lesquels le nombre attendu de symboles pour un nombre donné de bits du flux de seconds éléments binaires est différent d'un nombre connu maximal de symboles. Ainsi, la première passe de l'étape 300 démarre à l'état initial du treillis et construit successivement les différentes sections du treillis. Au cours de cette passe avant, il n'est pas possible de savoir quels sont les chemins qui ne respectent pas la contrainte de terminaison. Une fois la passe avant terminée, les états de la dernière section (n=N) du treillis qui ne respectent pas la contrainte sont supprimés. La passe arrière permet alors de supprimer toutes les branches qui n'aboutissent pas.

A l'étape 304, les probabilités obtenues des passes avant et arrière sont combinées sous la forme d'un produit pour chaque valeur de n variant de 1 à N pour obtenir les probabilités $P(X_n,K_n|Y)$ pour chaque état n. De cette manière sont estimées les probabilités liées aux transitions du treillis construit.

A l'étape 306, le produit de l'équation (4) est effectué sur les probabilités $P(X_n,K_n|Y_1^n)$ avec n variant de 1 à N. Ce produit est effectué pour les différentes combinaisons possibles de ces probabilités. Ainsi, la probabilité $P(X,K|Y)$ la plus grande est retenue et les probabilités $P(X_n,K_n|Y)$ constituant ce produit permettent de déterminer le chemin le plus vraisemblable dans le treillis. A partir du treillis et de la table correspondante du modèle produit source/décodeur, il est possible de déterminer les symboles correspondant à ce chemin et de reconstituer une séquence de symboles $S_1^K$.

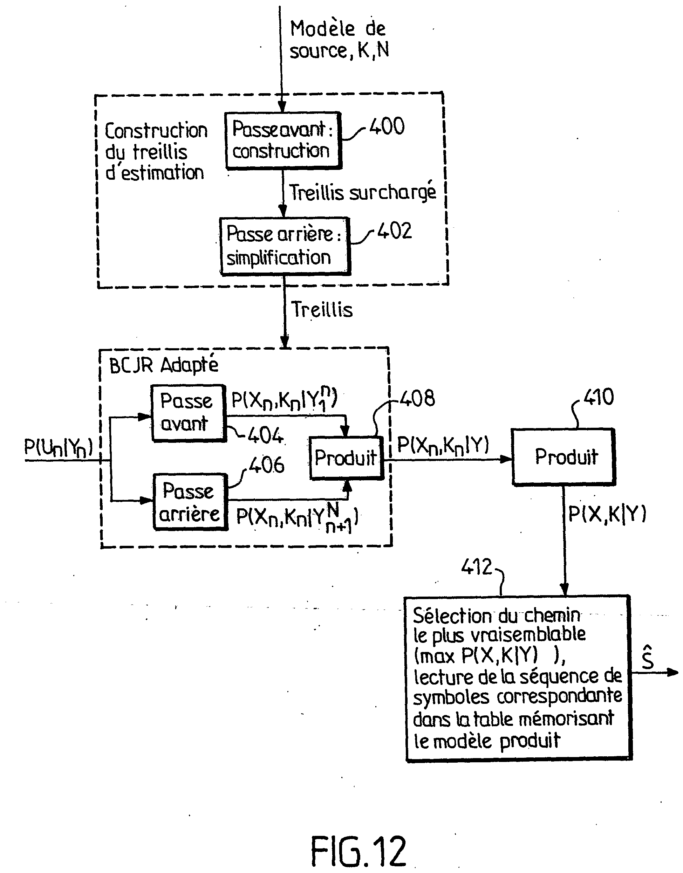

Dans une autre réalisation possible, le treillis sur lequel l'estimation est effectuée peut être pré-calculé et mémorisé à partir du modèle produit source/décodeur et de la longueur N de la séquence de bits observée. Ainsi, en référence à la figure 12, à partir du modèle source/décodeur et des valeurs de K et N, le treillis est construit à l'étape 400 en une passe avant et simplifié par une passe arrière à l'étape 402. Ce treillis est stocké en mémoire pour être utilisé à chaque arrivée de train de bits pour lequel le modèle source/décodeur et les valeurs K et N sont les mêmes.

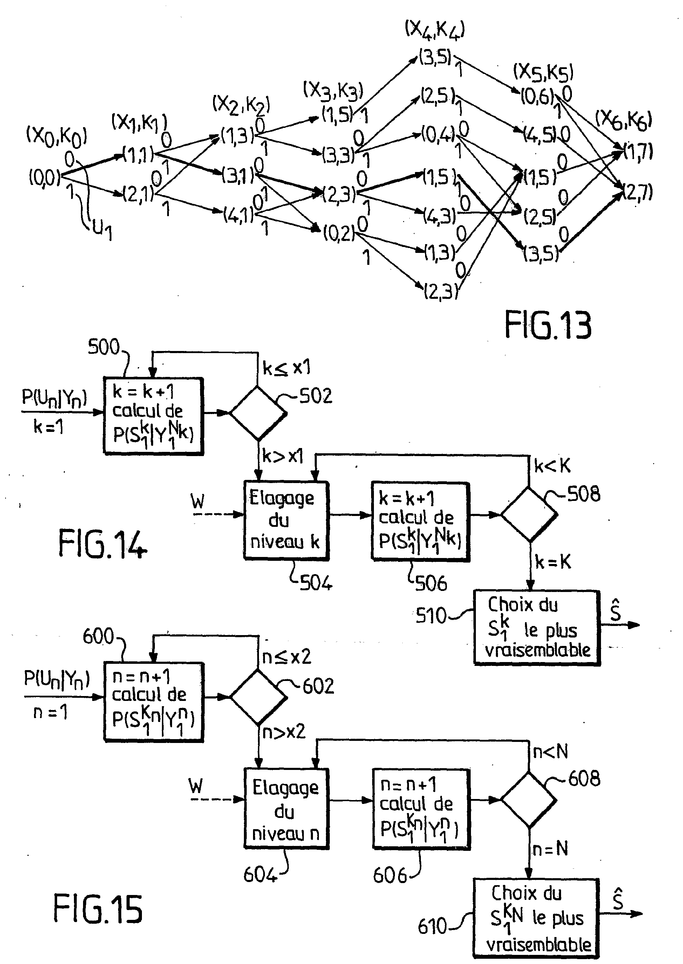

Pour un train de bits reçus comprenant N=6 bits, pour un nombre connu de symboles à trouver K=7 et pour un modèle de source/décodeur illustré en figure 9A, la construction du treillis est illustré en figure 13. Ce treillis comporte, à chaque état $(X_n,K_n)$, plusieurs valeurs couples $(X_n,K_n)$. Par exemple, le couple $(X_1,K_1)$ peut prendre les valeurs (1, 1) ou (2, 1) selon que le bit émis $U_1$ a pour valeur 0 ou 1.

A chaque arrivée de train de bits (ayant le même modèle, les mêmes valeurs de K et N que le treillis), une passe avant et une passe arrière sont effectuées sur le train de bits aux étapes 404 et 406, par exemple de façon parallèle. Les probabilités $P(X_n,K_n|Y_1^n)$ et $P(Y_{n+1}^N | X_n,K_n)$ sont calculées comme indiqué aux équations (6) et (7). Le produit de ces probabilités est effectué à l'étape 408 pour chaque valeur de n et correspond à chaque transition du treillis. Il est ensuite procédé au calcul du produit des probabilités pour n variant de 1 à N à l'étape 410 comme indiqué en (4) pour obtenir des probabilités $P(X,K|Y)$. Il est gardé le maximum parmi ces probabilités $P(X,K|Y)$ pour déterminer le chemin le plus vraisemblable sur le treillis et la séquence de symboles correspondante.

Selon l'exemple de la figure 13, le chemin le plus vraisemblable (obtenant la plus grande probabilité $P(X,K|Y)$) est marqué en gras. La suite des états $(X_0,K_0)$, ...,$(X_N,K_N)$ permet, à la lecture de la table 8A de déterminer la séquence de symboles correspondant à ce chemin.

Il a été présenté un procédé de décodage optimal de codes quasi-arithmétiques. Ce procédé nécessite la création et la manipulation d'un treillis d'estimation, comme par exemple celui de la figure 13. La taille de ce treillis dépend du nombre d'états du modèle produit source/décodeur (4 états sont possibles pour le modèle produit source/décodeur de la figure 9A par exemple) et de l'amplitude des valeurs que peut prendre la variable $K_n$ à chaque instant bit n. Le nombre d'états du modèle produit source/décodeur est lui-même dépendant du modèle de source binaire et du paramètre de précision du codage quasi-arithmétique T. Pour régler le compromis entre l'efficacité de compression du codeur quasi-arithmétique et la complexité du procédé d'estimation, il suffit donc de régler la valeur du paramètre T. Une valeur de T aussi petite que 4, par exemple, entraîne un débit excédent raisonnable. Si cependant une compression maximale est requise, T doit avoir une valeur beaucoup plus grande et la valeur minimale de T requise dépend de la distribution de la source. Dans la majeure partie de ces cas, la valeur de T est trop importante pour pouvoir utiliser le procédé d'estimation optimal décrit ci-dessus. Le nombre d'états du modèle produit source/décodeur peut également être trop important pour pouvoir pré-calculer ces états.

Un procédé d'estimation applicable au codage arithmétique et au codage quasi-arithmétique est maintenant décrit quelle que soit la précision T choisie, c'est-à-dire quelque soit l'efficacité en compression choisie.

Ce procédé s'appuie sur les même modèles de source, de codeur et de décodeur que ceux vus précédemment. Le nombre d'états des modèles de codeur et de décodeur étant trop important pour que ceux-ci puissent être être pré-calculés, le treillis d'estimation correspondant ne peut pas non plus être construit. Le procédé d'estimation proposé ci-après est donc basé sur l'exploration d'un sous-ensemble du treillis d'estimation, qui est considéré comme un arbre. Ce procédé est appelé procédé d'estimation séquentiel. Il peut s'appliquer à partir des modèles source/codeur et effectuer les calculs séquentiels en utilisant "l'horloge symbole", c'est-à-dire un compteur incrémenté selon le nombre de symboles à trouver. Il peut également s'appliquer à partir des modèles source/décodeur et effectuer les calculs séquentiels en utilisant "l'horloge bit", c'est-à-dire un compteur incrémenté selon le nombre de bits à décoder. Ce deuxième procédé d'estimation est présenté pour une source binaire à titre d'exemple uniquement. Il peut également s'appliquer à une source M-aire (M>2).

La figure 14 illustre le procédé d'estimation séquentiel dit à horloge symbole, c'est à dire basé sur le modèle source/codeur. Ainsi, d'après la figure 8 représentant la structure de dépendance du modèle source/codeur, l'estimation de la séquence des états (X, N) pour un train de bits est équivalent à l'estimation de la séquence de transitions entre ces états, c'est à dire à l'estimation de la séquence S sachant les observations Y à la sortie du canal. Ceci se traduit par une formulation mathématique présentée en (8) où $\alpha$ désigne un facteur de normalisation. Dans le cas du codage arithmétique optimal (pour une valeur de T élevée), comme les bits émis sont distribués uniformément et indépendamment, ce facteur de normalisation est $P(U_1^N)/P(Y_1^N) = 1$.

A l'étape 500, la probabilité de décoder une séquence de symboles (de 1 à k) connaissant des bits du flux de seconds éléments binaires $P(S_1^k/Y_1^{Nk})$ pour chaque instant symbole k peut être calculée en une passe avant unique grâce à la décomposition de l'équation (9) où $N_k$ est le nombre total de bits émis lorsqu'on est dans l'état $X_k$. En tenant compte du modèle de source binaire défini à l'équation(1) et en considérant un canal sans mémoire, la probabilité d'observer les seconds éléments binaires correspondant à un état du modèle ne dépend que des premiers éléments binaires pour cet état, cette probabilité peut être réécrite comme indiqué à l'équation (10).

Le calcul est initialisé comme indiqué en (11) avec $S_1 = s_1$ pouvant prendre deux valeurs possibles 0 ou 1 dans le cas d'une source binaire, et M valeurs possibles dans le cas d'une source M-aire. $C_1$ est l'état de départ du modèle de source. Pour un canal considéré sans mémoire, le second terme de cette équation modélisant le bruit introduit par ce canal est donné à l'équation (12) comme le produit, pour un état $X_k$ donné du modèle source/codeur, des probabilités d'observer un second élément binaire $Y_n$ pour un premier élément binaire transmis $U_n$. Partant de cette initialisation, l'équation (10) est utilisée pour calculer $P(S_1^k/Y_1^{Nk})$ pour chaque instant symbole k consécutif.

Toutes les séquences de symboles possibles étant considérées, la taille du treillis d'estimation croît exponentiellement avec le nombre de symboles K. Ainsi, l'étape 502 autorise le calcul des probabilités $P(S_1^k/Y_1^{Nk})$ pour un nombre de symboles k variant de 1 à x1. Pour les symboles à partir de cette valeur x1, un élagage intervient à l'étape 504 pour maintenir une complexité du treillis d'estimation à un niveau désiré, x1 est un entier inférieur ou égal au nombre de symboles K.

L'élagage de l'étape 504 peut comporter différentes réalisations. A titre d'exemple, deux réalisations sont présentées ci-après. Les réalisations peuvent être combinées ou employées séparément.

Ainsi, dans une première réalisation de l'élagage de l'étape 504, seuls les W noeuds les plus vraisemblables d'un état $(X_k, N_k)$ sont sélectionnés et ceci à partir d'un nombre k = x1 pour garantir la significativité des probabilités calculées (appelées vraisemblances). La valeur de W dépend des ressources de mémoire disponibles. Ainsi, pour chaque état $(X_k, N_k)$, seules les W probabilités les plus grandes parmi les probabilités calculées de décoder une séquence de symboles (de 1 à k) connaissant des bits du flux de seconds éléments binaires $P(S_1^k/Y_1^{Nk})$ sont sélectionnées et mémorisées. Dans une variante, il est possible de garantir une terminaison correcte de l'estimation en raffinant cette contrainte. Ainsi, seuls les w noeuds les plus vraisemblables seront sélectionnés et conservés pour chaque valeur possible de $N_k$ (correspondant à l'horloge symbole). $N_k$ est le nombre de bits émis pour k symboles codés lors du codage. La relation entre W et w est donnée en (19) avec $N_{kmax}$ et $N_{kmin}$ dépendant respectivement de la probabilité de la séquence $S_1^k$ la plus et la moins vraisemblable.

Dans une deuxième réalisation de l'élagage de l'étape 504, le critère d'élagage est basé sur un seuil appliqué sur la vraisemblance des chemins. La vraisemblance d'un chemin est donnée par l'équation (8) (horloge symbole). Dans cette équation, les termes $P(Y|U)$ sont liés au modèle de canal comme indiqué dans l'équation (12). $P(Y_n=y_n|U_n=u_n)$ représente la probabilité qu'un bit $y_n$ soit observé sachant qu'un bit $u_n$ a été transmis ou la probabilité de recevoir un bit $y_n$ sachant q'un bit $u_n$ a été émis, ce qui équivaut à la probabilité que le bit observé soit erroné. Soit p la probabilité d'erreur binaire moyenne qui est fixée arbitrairement comme tolérable sur le canal durant l'estimation. L'élagage consiste à supprimer tous les chemins pour lesquels la probabilité d'erreur binaire moyenne à la sortie du canal est supérieure à p. Ainsi, à chaque instant symbole $N_k$, le critère d'élagage comprend un seuil p comparé aux probabilités $P(Y_{Nk}|U_{Nk})$ de manière à ce que tous les chemins du treillis d'estimation pour lesquels est vérifié $P(Y_{Nk}|U_{Nk}) < (1-p)^{Nk}$, soient supprimés. Seules sont mémorisées les probabilités de décoder une séquence de symboles (de 1 à k) connaissant des bits du flux de seconds éléments binaires $P(S_1^k/Y_1^{Nk})$, calculées à partir des probabilités $P(Y_{Nk}|U_{Nk})$ plus grandes que le seuil minimal p.

Après incrémentation de la valeur k d'une unité, la probabilité $P(S_1^k/Y_1^{Nk})$ pour le nombre de symboles Nk (avec k>x) est calculée à l'étape 506. L'élagage réalisé à l'étape 504 est réitéré pour ce nouvel instant symbole Nk. Les étapes 504 et 506 sont effectuées pour une valeur k incrémentée jusqu'à la valeur K. A l'étape 510, une fois la valeur K atteinte, les probabilités $P(S_1^K/Y_1^{NK})$ marginales a posteriori sont connues pour toutes les séquences $s_1^K$ possibles. La séquence $s_1^K$ la plus vraisemblable est choisie, c'est-à-dire la séquence pour laquelle la probabilité $P(S_1^K/Y_1^{NK})$ est la plus grande parmi les séquences possibles du treillis d'estimation obtenu.

Lorsque le nombre de bits N est connu, il peut constituer une contrainte sur la terminaison du treillis d'estimation et les chemins qui ne respectent pas la contrainte N ne sont pas considérés.

La figure 15 illustre le procédé d'estimation séquentiel dit à horloge bit, c'est à dire basé sur le modèle source/décodeur. Ainsi, d'après la figure 10 représentant la structure de dépendance du modèle source/décodeur, l'estimation de la séquence des états (X, K) pour obtenir un train de symboles est équivalente à l'estimation de la séquence de transitions entre ces états, c'est à dire à l'estimation de la séquence S sachant les observations Y à la sortie du canal. Ceci se traduit par une formulation mathématique présentée en (13) où $\alpha$ désigne un facteur de normalisation. Dans le cas du codage arithmétique optimal (pour une valeur de T élevée), les bits émis étant distribués uniformément et indépendamment, ce facteur de normalisation est $P(U_1^n)/P(Y_1^n)=1$.

A l'étape 600, la probabilité de décoder une séquence de $K_n$ symboles connaissant les bits du flux de seconds éléments binaires $P(S_1^{Kn}/Y_1^n)$ pour chaque bit n (défini ultérieurement) peut être calculée en une passe avant unique grâce à la décomposition de l'équation (13) où $K_n$ est le nombre total de symboles décodés à la réception du bit n dans l'état $X_n$. En tenant compte du modèle de source binaire qui définit en (2) les probabilités de transition entre états $(X_n,K_n)$ et $(X_{n+1},K_{n+1})$, la probabilité $P(S_1^{Kn})$ d'obtenir une séquence de symbole $S_1^{Kn}$ s'exprime de manière récurrente selon l'équation (14) en utilisant l'équation (15). En considérant un canal sans mémoire, c'est-à-dire que la probabilité d'observer les seconds éléments binaires correspondant à un état du modèle ne dépend que des premiers éléments binaires transmis pour cet état, la probabilité $P(Y_1^n/U_1^n)$ peut être réécrite et permet d'obtenir la probabilité $P(S_1^{Kn}/Y_1^n)$ comme indiqué en (16).

Comme dans le cas de la figure 14, le calcul de la probabilité $P(S_1^{Kn}/Y_1^n)$ par l'équation (16) est initialisée pour n=1, $S_1 = s_1$ pouvant prendre deux valeurs possibles 0 ou 1 dans le cas d'une source binaire, et M valeurs possibles dans le cas d'une source M-aire. $C_1$ est l'état de départ du modèle de source. Partant de cette initialisation, l'équation (16) est utilisée pour calculer $P(S_1^{Kn}/Y_1^n)$ pour chaque instant bit n consécutif.

Toutes les séquences de symboles possibles étant considérées, la taille du treillis d'estimation croît exponentiellement avec le nombre de symboles K pouvant être estimé. Ainsi, l'étape 602 autorise le calcul des probabilités $P(S_1^{Kn}/Y_1^n)$ à l'étape 600 pour un nombre de bits n variant de 1 à x2, x2 étant un entier désignant un nombre seuil de bits. Pour les bits à partir de cette valeur x2, un élagage intervient à l'étape 604 pour maintenir une complexité du treillis d'estimation à un niveau désiré.

L'élagage de l'étape 604 peut comporter différentes réalisations correspondant aux réalisations de l'étape 504 de la figure 14. Les réalisations peuvent être combinées ou employées séparément.

Ainsi, dans une première réalisation de l'élagage de l'étape 604, seuls les W noeuds les plus vraisemblables d'un état $(X_n, K_n)$ sont gardés et ceci à partir d'un nombre n = x2 pour garantir la significativité des probabilités calculées (appelées vraisemblances). Ainsi, pour chaque état $(X_n, K_n)$, seules les W probabilités les plus grandes parmi les probabilités calculées de décoder une séquence de $K_n$ symboles connaissant des bits du flux de seconds éléments binaires $P(S_1^k/Y_1^{Nk})$ sont mémorisées.

Dans une variante, il est possible de conserver seuls les w noeuds les plus vraisemblables pour chaque valeur possible de $K_n$ (correspondant à l'horloge bit). $K_n$ est le nombre de symboles émis pour n bits reçus lors du décodage. La relation entre W et w est donnée en (20) avec $K_{nmax}$ et $K_{nmin}$ dépendant respectivement de la probabilité de la séquence $S_1^k$ la plus et la moins vraisemblable.

Dans une deuxième réalisation de l'élagage de l'étape 604, le critère d'élagage est basé sur un seuil appliqué sur la vraisemblance des chemins. La vraisemblance d'un chemin est donnée par l'équation (13) (horloge bit). Dans cette équation, les termes $P(Y|U)$ sont liés au modèle de canal comme indiqué dans l'équation (16). Comme proposé pour la figure 13, l'élagage consiste à supprimer tous les chemins pour lesquels la probabilité d'erreur binaire moyenne à la sortie du canal est supérieure à p. Ainsi, à chaque instant bit n, le critère d'élagage comprend un seuil p comparé aux probabilités $P(Yn|Un)$ de manière à ce que tous les chemins du treillis d'estimation pour lesquels est vérifié $P(Y_n|U_n)$ < $(1-p)^n$, soient supprimés. Seules sont mémorisées les probabilités de décoder un prochain symbole connaissant des bits du flux de seconds éléments binaires $P(S_1^{Kn}/Y_1^n)$, calculées à partir des probabilités $P(Y_n|U_n)$ plus grandes que le seuil minimal p. Ainsi, à chaque instant bit n, tous les chemins du treillis d'estimation pour lesquels le critère d'élagage $P(Y_n|U_n)$ < $(1-p)^n$ est rempli, sont supprimés.

Après incrémentation de la valeur n d'une unité, la probabilité $P(S_1^{Kn}/Y_1^n)$ pour le nombre de bits n (avec n>x2) est calculée à l'étape 606. L'élagage réalisé à l'étape 604 estréitéré pour ce nouvel instant bit $K_n$. Les étape 604 et 606 sont effectuées pour une valeur n incrémentée jusqu'à la valeur N. A l'étape 610, une fois la valeur N atteinte, la séquence $S_1^N$ la plus vraisemblable est choisie, c'est-à-dire la séquence pour laquelle la probabilité $P(S_1^K/Y_1^N)$ est la plus grande parmi les séquences possibles du treillis d'estimation obtenu.

A la fin de l'estimation, les probabilité $P(S_1^K/Y_1^N)$ marginales a posteriori sont connues pour toutes les séquences $s_1^K$ restant après élagage.

Les contraintes de terminaison mentionnées peuvent être vues comme un moyen de forcer la synchronisation à la fin de la séquence de symboles. En effet, elles contraignent le décodeur à obtenir la bonne correspondance entre le nombre de symboles décodés et le nombre de bits observés. Cependant, ces contraintes n'ont pas d'effet de synchronisation sur le milieu de la séquence.

L'addition à la séquence de symboles d'information complémentaire permet de favoriser la re-synchronisation sur l'ensemble de la séquence. Ainsi, des symboles supplémentaires, ou marqueurs, sont introduits à des positions connues dans la séquence de symboles. Le choix de ces symboles est arbitraire, et se base sur le principe des techniques décrites dans (2, 4, 11, 5, 14). A titre d'exemple uniquement, un des symboles dans l'alphabet peut être choisi ou le dernier symbole codé peut être répété. Ces marqueurs sont insérés à position connue suivant l'horloge symbole. Par conséquent, la position des bits supplémentaires correspondants dans le train binaire dépend de la séquence de symboles codée, et est aléatoire.

Bien évidemment, les procédés développés précédemment doivent tenir compte de cette information supplémentaire. Cette connaissance à priori peut être exploitée par les procédés d'estimation. La variable $K_n$ (k à horloge symbole) indique quand un marqueur est attendu. Les probabilités de transition correspondantes dans le treillis d'estimation sont mises à jour en conséquence. Une probabilité nulle est affectée à toutes les transitions qui n'émettent pas les marqueurs attendus, alors qu'une probabilité de 1 est affectée aux autres. Par conséquent, certains chemins dans le treillis peuvent être supprimés, ce qui amène une réduction du nombre d'états et une meilleure capacité de re-synchronisation.

Des exemples de procédés de décodage robuste sont décrits ci-dessus à titre d'exemple. D'autres variantes peuvent être envisagées. De plus, d'autres critères d'élagage peuvent être prévues et combinés avec les procédés de l'invention. La conversion M-aire/binaire n'est pas indispensable, mais permet d'utiliser de petites valeurs de T. Les procédés de décodage présentés ci-dessus pour des sources binaires peuvent également fonctionner pour des sources M-aires.

Comme développé dans la description ci-dessus, l'invention propose un procédé de décodage robuste de codes arithmétiques basé sur l'utilisation de codes de type codes arithmétiques comprenant les codes arithmétiques à précision réduite, appelés codes quasi-arithmétiques. La précision de ces codes quasi-arithmétiques est un paramètre ajustable en fonction de l'effet recherché. Une précision très élevée permet d'atteindre des performances en compression identiques aux codes arithmétiques. Une précision plus faible permet d'accroître la robustesse, au prix d'une perte raisonnable en compression.

Comparée à un décodage dit "instantané" classique, l'invention permet de réduire fortement le phénomène de désynchronisation du décodeur. Comparée à d'autres méthodes classiques de décodage dite "séquentielles" ou sur structures d'arbres, l'invention offre une plus grande souplesse pour ajuster un compromis entre l'efficacité de compression/la robustesse/la complexité du décodage. En effet, l'invention comprend un ensemble de procédés pouvant être choisis selon la complexité permise par le terminal, selon le taux d'erreur observé sur le canal. Un procédé de décodage séquentiel comprend un mécanisme de synchronisation couplé à une technique d'élagage qui permet de contrôler la complexité du processus de décodage. Un procédé de décodage sur treillis avec paramétrisation du compromis complexité/robustesse/compression permet d'utiliser le procédé de manière couplée avec un décodeur de canal (décodeur de codes convolutifs), utilisation difficile avec les procédés séquentiels traditionnels.

Dans l'invention proposée, il doit être clair que les éléments d'ordre mathématique décrits n'ont pas d'intérêt en eux-mêmes, mais seulement dans la mesure où ils concernent des flux d'informations (par exemple signal sonore, vidéo), soumis à des contraintes matérielles.

1 Annexe 1

$$P(C_{k+1}|C_k) = P(S_{k+1}|C_k) \tag{1}$$

$$\prod_{k=K_n+1}^{K_{n+1}} \mathbb{P}(S_k|C_{k-1}) \tag{2}$$

$$\hat{X} = \arg \max_x \mathbb{P}(X = x|Y). \tag{3}$$

$$\mathbb{P}(X, K|Y) = \prod_{n=1}^{N} \mathbb{P}(X_n, K_n|Y). \tag{4}$$

$$\mathbb{P}(X_n, K_n|Y) = \frac{\mathbb{P}(X_n, K_n|Y_1^n) \cdot \mathbb{P}(Y_{n+1}^N|X_n, K_n)}{\mathbb{P}(Y_{n+1}^N)}, \\ \propto \mathbb{P}(X_n, K_n|Y_1^n) \cdot \mathbb{P}(Y_{n+1}^N|X_n, K_n), \tag{5}$$

$$\mathbb{P}(X_n = x_n, K_n = k_n|Y_1^n) = \sum_{(x_{n-1},k_{n-1})} \mathbb{P}(X_{n-1} = x_{n-1}, K_{n-1} = k_{n-1}|Y_1^{n-1}) \cdot \\ \mathbb{P}(X_n = x_n, K_n = k_n|X_{n-1} = x_{n-1}, K_{n-1} = k_{n-1}) \cdot \\ \mathbb{P}(U_n = u_{(x_{n-1},k_{n-1})(x_n,k_n)}|Y_n). \tag{6}$$

$$\mathbb{P}(Y_{n+1}^N|X_n = x_n, K_n = k_n) = \sum_{(x_{n+1},k_{n+1})} \mathbb{P}(Y_{n+2}^N|X_{n+1} = x_{n+1}, K_{n+1} = k_{n+1}) \cdot \\ \mathbb{P}(X_{n+1} = x_{n+1}, K_{n+1} = k_{n+1}|X_n = x_n, K_n = k_n) \cdot \\ \mathbb{P}(U_{n+1} = u_{(x_n,k_n)(x_{n+1},k_{n+1})}|Y_{n+1}). \tag{7}$$

$$\mathbb{P}(S_1^K|Y_1^N) = \mathbb{P}(S_1^K) \cdot \mathbb{P}(U_1^N|Y_1^N) \\ \propto \mathbb{P}(S_1^K) \cdot \mathbb{P}(Y_1^N|U_1^N), \tag{8}$$

$$\mathbb{P}(S_1^k|Y_1^{N_k}) \propto \mathbb{P}(S_1^{k-1}|Y_1^{N_{k-1}}) \cdot \mathbb{P}(S_k|S_{k-1}) \cdot \\ \mathbb{P}(Y_{N_{k-1}+1}^{N_k}|Y_1^{N_{k-1}}, U_1^{N_k}), \tag{9}$$

$$\mathbb{P}(S_1^k|Y_1^{N_k}) \propto \mathbb{P}(S_1^{k-1}|Y_1^{N_{k-1}}) \cdot \mathbb{P}(S_k|C_{k-1}) \cdot \\ \mathbb{P}(Y_{N_{k-1}+1}^{N_k}|U_{N_{k-1}+1}^{N_k}) \tag{10}$$

$$\mathbb{P}(S_1 = s_1 | Y_1^{N_1 = n_1} = y_1^{N_1 = n_1}) \quad \propto \quad \mathbb{P}(S_1 = s_1 | C_1) \cdot$$
$$\mathbb{P}(Y_1^{N_1} = y_1^{n_1} | U_1^{N_1} = u_1^{n_1}), \tag{11}$$

$$\mathbb{P}(Y_{N_{k-1}+1}^{N_k} = y_{n_{k-1}+1}^{n_k} | U_{N_{k-1}+1}^{N_k} = u_{n_{k-1}+1}^{n_k}) =$$
$$\left| \begin{array}{l} \prod_{n=N_{k-1}+1}^{N_k} \mathbb{P}(Y_n = y_n | U_n = u_n) \text{ if } N_k > N_{k-1} \\ 1 \text{ sinon.} \end{array} \right. \tag{12}$$

$$\mathbb{P}(S_1^{K_n} | Y_1^n) \quad \propto \quad \mathbb{P}(S_1^{K_n}) \cdot \mathbb{P}(Y_1^n | U_1^n) \tag{13}$$

$$\mathbb{P}(S_1^{K_n}) = \mathbb{P}(S_1^{K_{n-1}}) \cdot \mathbb{P}(S_{K_{n-1}+1}^{K_n} | S_1^{K_{n-1}}), \tag{14}$$

$$\mathbb{P}(S_{K_{n-1}+1}^{K_n} | S_1^{K_{n-1}}) =$$
$$\left| \begin{array}{l} \prod_{k=K_{n-1}+1}^{K_n} \mathbb{P}(S_k | C_{k-1}) \text{ si } K_n > K_{n-1} \\ 1 \text{ sinon.} \end{array} \right. \tag{15}$$

$$\mathbb{P}(S_1^{K_n} | Y_1^n) \quad \propto \quad \mathbb{P}(S_1^{K_{n-1}}) \cdot \mathbb{P}(Y_1^{n-1} | U_1^{n-1}) \cdot$$
$$\mathbb{P}(Y_n | U_n) \cdot \prod_{k=K_{n-1}+1}^{K_n} \mathbb{P}(S_k | C_{k-1})$$
$$\propto \quad \mathbb{P}(S_1^{K_{n-1}} | Y_1^{n-1}) \cdot \mathbb{P}(Y_n | U_n) \cdot \prod_{k=K_{n-1}+1}^{K_n} \mathbb{P}(S_k | C_{k-1}) \tag{16}$$

$$\mathbb{P}(X_n = x_n, K_n = k_n | X_{n-1} = x_{n-1}, K_{n-1} = k_{n-1}) = \prod_{k=K_{n-1}+1}^{K_n} \mathbb{P}(S_k | C_{k-1}) \tag{17}$$

$$\mathbb{P}(Y_n | U_n) < (1-p)^n \tag{18}$$

$$W = (N_{kmax} - N_{kmin} + 1)w \tag{19}$$

$$W = (K_{nmax} - K_{nmin} + 1)w \tag{20}$$

$$\mathbb{P}(Y_i = 0 | U_i = 0) = 1 - p$$
$$\mathbb{P}(Y_i = 1 | U_i = 0) = p$$
$$\mathbb{P}(Y_i = 0 | U_i = 1) = p$$
$$\mathbb{P}(Y_i = 1 | U_i = 1) = 1 - p \tag{21}$$

**Revendications**

1. Procédé de décodage, dans un décodeur arithmétique ou quasi-arithmétique, d'éléments binaires reçus d'un canal en des symboles x-aires comprenant les étapes suivantes:

   - recevoir dudit canal un flux de N seconds éléments binaires $Y_i$ correspondants à N premiers éléments binaires $U_i$ transmis, par l'intermédiaire dudit canal, d'un codeur arithmétique ou quasi-arithmétique vers ledit décodeur avec i compris entre 1 et N, ledit codeur codant une source de symboles;
   - décoder lesdits N seconds éléments binaires $Y_i$ en un flux de K symboles x-aires $S_j$ avec j compris entre 1 et K;

   **caractérisé en ce que** l'étape de décodage comprend :

   a. calculer (306, 410) des probabilités d'aboutir dans des états produits connaissant des bits du flux de seconds éléments binaires $Y_i$,
   à partir d'un modèle dudit canal,
   d'un modèle de ladite source et
   d'un modèle produit définissant une correspondance entre lesdits symboles x-aires $S_j$ et lesdits premiers éléments binaires $U_i$, à partir d'états produits dans un diagramme d'états "produit", un état produit comprenant un état source et un état d'un modèle dudit codeur ou dudit décodeur arithmétique ou quasi-arithmétique, et
   b. déterminer le flux (308, 412, 510, 610) de symboles x-aires le plus probable à partir des probabilités calculées à l'étape a.

2. Procédé selon la revendication 1, **caractérisé en ce que** chaque état produit comprend un état source (Ck) et un état dudit modèle dudit codeur arithmétique ou quasi-arithmétique, ledit état dudit modèle dudit codeur comprenant : une valeur de borne inférieure ($lowS_k$) d'un intervalle résultant de subdivisions successives d'un intervalle correspondant au codage d'une séquence de k symboles x-aires, une valeur de borne supérieure dudit intervalle ($upS_k$) et un compteur ($N_k$) représentant le nombre de premier éléments binaires associés auxdits k premiers symboles x-aires.

3. Procédé selon la revendication 1, **caractérisé en ce que** chaque état produit comprend un état source et un état dudit modèle dudit décodeur arithmétique ou quasi-arithmétique, ledit état dudit modèle dudit décodeur comprenant : une valeur d'une borne inférieure ($lowU_n$) d'un premier segment d'un intervalle défini par la réception d'une séquence de n seconds éléments binaires, une valeur d'une borne supérieure ($upU_n$) dudit premier segment, une valeur d'une borne inférieure ($lowS_{Kn}$) d'un second segment dudit intervalle obtenu quand une séquence de symboles x-aires est déterminée à partir desdits n seconds éléments binaires, une valeur d'une borne supérieure ($upS_{Kn}$) dudit second intervalle et un compteur ($K_n$) représentant le nombre de symboles x-aires déterminés associés auxdits n seconds éléments binaires reçus.

4. Procédé selon la revendication 1, **caractérisé en ce qu'**il comprend une étape de détermination d'un flux de symboles m-aires à partir du flux de symboles x-aires déterminé,
   m étant supérieur ou égal à x et le modèle source comprenant des transitions associées à une correspondance entre des symboles m-aires ($A_k$) sources et des symboles x-aires cibles ($S_k$).

5. Procédé selon l'une des revendications précédentes, **caractérisée en ce que** les modèles de produit et de codeur ou de décodeur sont de type arithmétique.

6. Procédé selon l'une des revendications précédentes, **caractérisé en ce que** l'étape a. comprend le calcul, par étapes, des probabilités de décoder un symbole x-aire connaissant des bits du flux de seconds éléments binaires.

7. Procédé selon la revendication 6, **caractérisé en ce que** l'étape a. comprend l'élaboration d'un arbre constitué d'états reliés par des transitions, chaque état correspondant à une étape de calcul de probabilités et chaque transition, au départ d'un état, correspondant à l'une de ces probabilités calculées.

8. Procédé selon les revendications 1 et 7, **caractérisé en ce que** l'étape b. comprend le calcul du produit des probabilités correspondant à des transitions successives dans l'arbre et la sélection du produit le plus grand correspondant aux transitions successives les plus probables et au flux de symboles x-aires le plus probable.

9. Procédé selon les revendications 6 et 8, **caractérisé en ce que** l'étape a. comprend le calcul, pour un nombre donné de symboles x-aires successifs à décoder, des probabilités de décoder une séquence de symboles x-aire connaissant des bits du flux de seconds éléments binaires.

10. Procédé selon les revendications 6 et 8, **caractérisé en ce que** l'étape a. comprend le calcul, pour un nombre donné de bits successifs du flux de seconds éléments binaires, des probabilités de décoder une séquence de symboles x-aire, connaissant des bits du flux de seconds éléments binaires.

11. Procédé selon l'une des revendications 1 à 5, **caractérisé en ce qu'**à partir du modèle produit établissant ladite correspondance, l'étape a. comprend

c1. la construction successive d'états reliés par des transitions d'un diagramme d'états produit depuis un état d'origine à un état final, chaque état définissant un nombre attendu de symboles x-aires décodés pour un nombre donné de bits du flux de seconds éléments binaires depuis l'état d'origine.

12. Procédé selon la revendication 11, **caractérisé en ce que** la construction de l'étape a. comprend

c2. la suppression successive d'états du diagramme d'états produit, depuis l'état final à l'état d'origine, pour lesquels le nombre attendu de symboles x-aires pour un nombre donné de bits du flux de seconds éléments binaires est différent d'un nombre connu maximal de symboles x-aires

13. Procédé selon l'une des revendications 11 à 12, **caractérisé en ce que** l'étape a. comprend

c1. le calcul, après chaque état construit, des premières probabilités successives d'aboutir dans un état donné connaissant des bits passés du flux de seconds éléments binaires,
c2. le calcul, pour chaque état depuis l'état final à l'état d'origine, des secondes probabilités successives d'observer des prochains bits du flux de seconds éléments binaires connaissant cet état donné.

14. Procédé selon l'une des revendications 11 à 12, **caractérisé en ce que** l'étape a. comprend

c3. le calcul, pour chaque état du diagramme depuis l'état d'origine à l'état final, des premières probabilités successives d'aboutir dans cet état donné connaissant les bits passés du flux de seconds éléments binaires, et, pour chaque état depuis l'état final à l'état d'origine, des secondes probabilités successives d'observer des prochains bits du flux de seconds éléments binaires connaissant un état donné.

15. Procédé selon l'une des revendications 11 à 14, **caractérisé en ce que** l'étape a. comprend le calcul de la probabilité d'aboutir dans cet état donné connaissant les bits du flux de seconds éléments binaires en effectuant le produit des premières et deuxièmes probabilités pour chaque état.

16. Procédé selon les revendications 1 et 15, **caractérisé en ce que** l'étape b. comprend le calcul des produits de probabilités des différents états successifs possibles puis la sélection du produit maximal.

17. Procédé selon les revendications 11 et 16, **caractérisé en ce que**, la correspondance définie par le modèle produit étant établie sous la forme d'une table, l'étape b. comprend l'établissement du flux de symboles x-aires correspondant à ces états successifs par lecture de ladite table.

18. Dispositif de décodage arithmétique ou quasi-arithmétique d'éléments binaires reçus d'un canal en des symboles x-aires comprenant,
des moyens pour recevoir dudit canal un flux de N seconds éléments binaires $Y_i$ correspondants à N premiers éléments binaires $U_i$ transmis, par l'intermédiaire dudit canal, d'un codeur arithmétique ou quasi-arithmétique vers ledit décodeur avec i compris entre 1 et N , ledit codeur codant une source de symboles ;
des moyens de décoder lesdits N seconds éléments binaires $Y_i$ en un flux de K symboles x-aires $S_j$ avec j compris entre 1 et K;
**caractérisé en ce qu'**il comprend
des moyens pour calculer des probabilités d'aboutir dans des états produits connaissant des bits du flux de seconds éléments binaires $Y_i$, à partir d'un modèle dudit canal,
d'un modèle de ladite source et
d'un modèle produit définissant une correspondance entre lesdits symboles x-aires $S_j$ et lesdits premiers éléments binaires $U_i$, en fonction d'états produits dans un diagramme d'états "produit", un état produit comprenant un état source et un état d'un modèle dudit codeur ou dudit décodeur arithmétique ou quasi-arithmétique, et

des moyens pour déterminer le flux de symboles x-aires le plus probable à partir des probabilités calculées.

**19.** Dispositif selon la revendication 18, **caractérisé en ce que** chaque état produit comprend un état source (Ck) et un état dudit modèle dudit codeur arithmétique ou quasi-arithmétique, ledit état de modèle de codeur comprenant : une valeur de borne inférieure (lowS$_k$) d'un intervalle résultant de subdivisions successives d'un intervalle correspondant au codage d'une séquence de k symboles x-aires, une valeur de borne supérieure dudit intervalle (upS$_k$) et un compteur (N$_k$) représentant le nombre de premier éléments binaires associés aux k premiers symboles x-aires.

**20.** Dispositif selon la revendication 18, **caractérisé en ce que** chaque état produit comprend un état source et un état dudit modèle dudit décodeur arithmétique ou quasi-arithmétique, ledit état dudit modèle dudit décodeur comprenant : une valeur d'une borne inférieure (lowU$_n$) d'un premier segment d'un intervalle défini par la réception d'une séquence de n seconds éléments binaires, une valeur d'une borne supérieure (upU$_n$) dudit premier segment, une valeur d'une borne inférieure (lowS$_{Kn}$) d'un second segment dudit intervalle obtenu quand une séquence de symboles x-aires est déterminée à partir desdits n seconds éléments binaires, une valeur d'une borne supérieure (upS$_{Kn}$) dudit second intervalle et un compteur (K$_n$) représentant le nombre de symboles x-aires déterminés associés auxdits n seconds éléments binaires reçus.

**Patentansprüche**

**1.** Verfahren zur Decodierung von binären Elementen in einem arithmetischen oder quasi arithmetischen Decoder, , die von einem Kanal in x-ären Symbolen empfangen werden, das die folgenden Schritte umfasst:

- Empfangen von dem besagten Kanal eines Stroms von N zweiten binären Elementen Y$_i$, die N ersten binären Elementen U$_i$ entsprechen, die, über den besagten Kanal von einem arithmetischen oder quasi arithmetischen Coder zu dem besagten Decoder übertragen werden, wobei i zwischen 1 und N liegt, wobei der besagte Coder eine Quelle von Symbolen codiert;
- Decodieren der besagten N zweiten binären Elemente Y$_i$ in einen Strom von K x-ären Symbolen S$_j$, wobei j zwischen 1 und K liegt;
**dadurch gekennzeichnet, dass** der Decodierungsschritt Folgendes umfasst:

a. Berechnen (306, 410) der Wahrscheinlichkeiten des Erreichens von Produktzuständen, bei Kenntnis von Bits des Stroms von zweiten binären Elementen Y$_i$,
anhand eines Modells des besagten Kanals,
eines Modells der besagten Quelle und
eines Produktmodells, das eine Übereinstimmung zwischen den besagten x-ären Symbolen S$_j$ und den besagten ersten binären Elementen U$_i$ festlegt, anhand von Produktzuständen in einem Zustandsdiagramm "Produkt", wobei ein Produktzustand einen Quellzustand und einen Zustand eines Modells des besagten Coders oder des besagten arithmetischen oder quasi arithmetischen Decoders umfasst, und
b. Bestimmen des wahrscheinlichsten Stroms (308, 412, 510, 610) von x-ären Symbolen anhand der im Schritt a. berechneten Wahrscheinlichkeiten.

**2.** Verfahren nach Anspruch 1, **dadurch gekennzeichnet, dass** jeder Produktzustand einen Quellzustand (Ck) und einen Zustand des besagten Modells des besagten arithmetischen oder quasi arithmetischen Coders umfasst, wobei der besagte Zustand des besagten Modells des besagten Coders umfasst: einen unteren Grenzwert (lowS$_k$) eines Intervalls resultierend aus aufeinanderfolgenden Unterabteilungen eines Intervalls, der mit der Codierung einer Sequenz von k x-ären Symbolen übereinstimmt, einen oberen Grenzwert des besagten Intervalls (upS$_k$) und einen Zähler (N$_k$), der die Anzahl an ersten binären Elementen, die mit den besagten k ersten x-ären Symbolen verbunden sind, darstellt.

**3.** Verfahren nach Anspruch 1, **dadurch gekennzeichnet, dass** jeder Produktzustand einen Quellzustand und einen Zustand des besagten Modells des besagten arithmetischen oder quasi arithmetischen Decoders umfasst, wobei der besagte Zustand des besagten Modells des besagten Decoders umfasst: einen unteren Grenzwert (lowU$_n$) eines ersten Segments eines Intervalls, der festgelegt wird durch den Empfang einer Sequenz von n zweiten binären Elementen, einen oberen Grenzwert (upU$_n$) des besagten ersten Segments, einen unteren Grenzwert (lowS$_{Kn}$) eines zweiten Segmentes des besagten Intervalls, der erhalten wird, wenn eine Sequenz von x-ären Symbolen anhand der besagten n zweiten binären Elemente bestimmt wird, einen oberen Grenzwert (upS$_{Kn}$) des besagten zweiten Intervalls und einen Zähler ($K_n$), der die Anzahl an bestimmten x-ären Symbolen, die mit den besagten empfangenen n zweiten binären Elementen verbunden sind, darstellt.

4. Verfahren nach Anspruch 1, **dadurch gekennzeichnet, dass** es einen Schritt zur Bestimmung eines Stroms von m-ären Symbolen anhand des bestimmten Stroms von x-ären Symbolen umfasst, wobei m höher oder gleich x ist und das Quellmodell Übergänge umfasst, die mit einer Übereinstimmung zwischen den m-ären Quell-Symbolen ($A_k$) und den x-ären Ziel-Symbolen ($S_k$) verbunden sind.

5. Verfahren nach einem der vorstehenden Ansprüche,
**dadurch gekennzeichnet, dass** die Produkt- und Coder- oder Decodermodelle vom Typ her arithmetisch sind.

6. Verfahren nach einem der vorstehenden Ansprüche,
**dadurch gekennzeichnet, dass** der Schritt a. die schrittweise Berechnung der Wahrscheinlichkeiten zum Decodieren eines x-ären Symbols bei Kenntnis von Bits des Stroms von zweiten binären Elementen umfasst.

7. Verfahren nach Anspruch 6, **dadurch gekennzeichnet, dass** der Schritt a. die Anfertigung eines Baums umfasst, der aus Zuständen gebildet wird, die durch Übergänge miteinander verbunden sind, wobei jeder Zustand einem Schritt zur Berechnung von Wahrscheinlichkeiten und jeder Übergang, zu Beginn eines Zustands, einer dieser berechneten Wahrscheinlichkeiten entspricht.

8. Verfahren nach den Ansprüchen 1 und 7, **dadurch gekennzeichnet, dass** der Schritt b. die Berechnung des Produkts der Wahrscheinlichkeiten umfasst, die aufeinanderfolgenden Übergängen in dem Baum entsprechen, und die Auswahl des größten übereinstimmenden Produktes mit den wahrscheinlichsten aufeinanderfolgenden Übergängen und mit dem wahrscheinlichsten Strom von x-ären Symbolen.

9. Verfahren nach den Ansprüchen 6 und 8, **dadurch gekennzeichnet, dass** der Schritt a., für eine gegebene Anzahl an zu decodierenden aufeinanderfolgenden x-ären Symbolen, die Berechnung der Wahrscheinlichkeiten zum Decodieren einer Sequenz von x-ären Symbolen bei Kenntnis von Bits des Stroms von zweiten binären Elementen umfasst.

10. Verfahren nach den Ansprüchen 6 und 8, **dadurch gekennzeichnet, dass** der Schritt a., für eine gegebene Anzahl an aufeinanderfolgenden Bits des Stroms von zweiten binären Elementen, die Berechnung der Wahrscheinlichkeiten zum Decodieren einer Sequenz von x-ären Symbolen bei Kenntnis von Bits des Stroms von zweiten binären Elementen umfasst.

11. Verfahren nach einem der Ansprüche 1 bis 5,
**dadurch gekennzeichnet, dass** anhand des Produktmodells, das die besagte Übereinstimmung festlegt, der Schritt a. umfasst:

c1. den aufeinanderfolgenden Aufbau von durch Übergänge verbundenen Zuständen eines Diagramms von Produktzuständen ab einem Ausgangszustand bis zu einem Endzustand, wobei jeder Zustand eine erwartete Anzahl an decodierten x-ären Symbolen für eine gegebene Anzahl an Bits des Stroms von zweiten binären Elementen ab dem Ausgangszustand festlegt.

12. Verfahren nach Anspruch 11, **dadurch gekennzeichnet, dass** der Aufbau des Schritts a. umfasst:

c2. das aufeinanderfolgende Entfernen von Zuständen des Diagramms von Produktzuständen, ab dem Endzustand bis zum Ausgangszustand, für welche die erwartete Anzahl an x-ären Symbolen für eine gegebene Anzahl an Bits des Stroms von zweiten binären Elementen von einer bekannten maximalen Anzahl an x-ären Symbolen verschieden ist.

13. Verfahren nach einem der Ansprüche 11 bis 12,
**dadurch gekennzeichnet, dass** der Schritt a. umfasst:

c1. die Berechnung, nach jedem aufgebauten Zustand, der ersten aufeinanderfolgenden Wahrscheinlichkeiten, einen gegebenen Zustand bei Kenntnis von vergangenen Bits des Stroms von zweiten binären Elementen zu erreichen,
c2. die Berechnung, für jeden Zustand ab dem Endzustand bis zum Ausgangszustand, der zweiten aufeinanderfolgenden Wahrscheinlichkeiten, die nächsten Bits des Stroms von zweiten binären Elementen bei Kenntnis dieses gegebenen Zustands zu beobachten.

14. Verfahren nach einem der Ansprüche 11 bis 12, **dadurch gekennzeichnet, dass** der Schritt a. umfasst:

   C3. die Berechnung, für jeden Zustand des Diagramms ab dem Ausgangszustand bis zum Endzustand, der ersten aufeinanderfolgenden Wahrscheinlichkeiten, diesen gegebenen Zustand bei Kenntnis der vergangenen Bits des Stroms von zweiten binären Elementen zu erreichen, und *[die Berechnung],* für jeden Zustand ab dem Endzustand bis zum Ausgangszustand, der zweiten aufeinanderfolgenden Wahrscheinlichkeiten, die nächsten Bits des Stroms von zweiten binären Elementen bei Kenntnis eines gegebenen Stroms zu beobachten.

15. Verfahren nach einem der Ansprüche 11 bis 14, **dadurch gekennzeichnet, dass** der Schritt a. die Berechnung der Wahrscheinlichkeit, diesen gegebenen Zustand bei Kenntnis der Bits des Stroms von zweiten binären Elementen zu erreichen, indem das Produkt der ersten und zweiten Wahrscheinlichkeiten für jeden Zustand gebildet wird, umfasst.

16. Verfahren nach den Ansprüchen 1 und 15, **dadurch gekennzeichnet, dass** der Schritt b. die Berechnung der Produkte von Wahrscheinlichkeiten der verschiedenen möglichen aufeinanderfolgenden Zustände, alsdann die Auswahl des maximalen Produkts umfasst.

17. Verfahren nach den Ansprüchen 11 und 16, **dadurch gekennzeichnet, dass** die durch das Produktmodell festgelegte Übereinstimmung in der Form einer Tabelle erstellt wird, der Schritt b. die Festlegung des Stroms von x-ären Symbolen, die diesen aufeinanderfolgenden Zuständen entsprechen, durch Lesen der besagten Tabelle umfasst.

18. Vorrichtung zur arithmetischen oder quasi arithmetischen Decodierung von binären Elementen, die von einem Kanal empfangen werden, in x-äre Symbole, umfassend
   Mittel zum Empfangen von dem besagten Kanal eines Stroms von N zweiten binären Elementen $Y_i$, die N ersten binären Elementen $U_i$ entsprechen, die, über den besagten Kanal, von einem arithmetischen oder quasi arithmetischen Coder an den besagten Decoder übertragen werden, wobei i zwischen 1 und N liegt, wobei besagter Coder eine Quelle von Symbolen codiert;
   Mittel zur Decodierung der besagten N zweiten binären Elemente $Y_i$ in einen Strom von K x-ären Symbolen $S_j$, wobei j zwischen 1 und K liegt;
   **dadurch gekennzeichnet**, das sie umfasst Mittel zur Berechnung der Wahrscheinlichkeiten des Erreichens von Produktzuständen bei Kenntnis von Bits des Stroms von zweiten binären Elementen $Y_i$, anhand eines Modells des besagten Kanals,
   ein Modell der besagten Quelle und
   ein Produktmodell, das eine Übereinstimmung zwischen den besagten x-ären Symbolen $S_j$ und den besagten ersten binären Elementen $U_i$ festlegt, in Abhängigkeit von Produktzuständen in einem Diagramm von "Produkt"zuständen, wobei ein Produktzustand einen Quellzustand und einen Zustand eines Modells des besagten Coders oder des besagten arithmetischen oder quasi arithmetischen Decoders umfasst, und
   Mittel zur Bestimmung des wahrscheinlichsten Stroms von x-ären Symbolen anhand der berechneten Wahrscheinlichkeiten.

19. Vorrichtung nach Anspruch 18, **dadurch gekennzeichnet, dass** jeder Produktzustand einen Quellzustand (Ck) und einen Zustand des besagten Modells des besagten arithmetischen oder quasi arithmetischen Coders umfasst, wobei der besagte Zustand des Modells des Coders umfasst: einen unteren Grenzwert ($lowS_k$) eines Intervalls resultierend aus aufeinanderfolgenden Unterabteilungen eines Intervalls, der mit der Codierung einer Sequenz von k x-ären Symbolen übereinstimmt, einen oberen Grenzwert des besagten Intervalls ($upS_k$) und einen Zähler ($N_k$), der die Anzahl an ersten binären Elementen, die mit den k ersten x-ären Symbolen verbunden sind, darstellt.

20. Vorrichtung nach Anspruch 18, **dadurch gekennzeichnet, dass** jeder Produktzustand einen Quellzustand und einen Zustand des besagten Modells des besagten arithmetischen oder quasi arithmetischen Decoders umfasst, wobei der besagte Zustand des besagten Modells des besagten Decoders umfasst: einen unteren Grenzwert ($lowU_n$) eines ersten Segments eines Intervalls, der festgelegt wird durch den Empfang einer Sequenz von n zweiten binären Elementen, einen oberen Grenzwert ($upU_n$) des besagten ersten Segments, einen unteren Grenzwert ($lowS_{Kn}$) eines zweiten Segmentes des besagten Intervalls, der erhalten wird, wenn eine Sequenz von x-ären Symbolen anhand der besagten n zweiten binären Elemente bestimmt wird, einen oberen Grenzwert ($upS_{Kn}$) des besagten zweiten Intervalls und einen Zähler ($K_n$), der die Anzahl an bestimmten x-ären Symbolen, die mit den besagten empfangenen n zweiten binären Elementen verbunden sind, darstellt.

**Claims**

1.  Decoding method, in an arithmetic or almost-arithmetic decoder, binary elements received from a channel in x-ary symbols comprising the following steps:

    - receive from said channel a stream of N second binary elements $Y_i$ corresponding to N first binary elements $U_i$ transmitted, by means of said channel, from an arithmetic or almost-arithmetic coder to said decoder with i between 1 and N, said coder coding a source of symbols;
    - decode said N second binary elements $Y_i$ into a stream of K x-ary symbols $S_j$ with j between 1 and K;

    **characterised in that** the decoding step comprises:

    a. calculate (306, 410) probabilities of resulting in product states knowing bits of the stream of second binary elements $Y_i$,
    from a model of said channel,
    from a model of said source and
    from a product model defining a correspondence between said x-ary symbols $S_j$ and said first binary elements $U_i$, from product states in a 'product' states diagram, a product state comprising a source state and a state of a model of said coder or of said arithmetic or almost-arithmetic decoder,
    b. determine the most probable stream (308. 412, 510, 610) of x-ary symbols from probabilities calculated in step a.

2.  Method according to claim 1, **characterised in that** each product state comprises a source state (Ck) and a state of said model of said arithmetic or almost-arithmetic coder, said state of said model of said coder comprising: a low limit value ($lowS_k$) of an interval resulting from successive subdivisions of an interval corresponding to the coding of a sequence of k x-ary symbols, an upper limit value of said interval ($upS_k$) and a counter ($N_k$) representing the number of first binary elements associated with said k first x-ary symbols.

3.  Method according to claim 1, **characterised in that** said product state comprises a source state and a state of said model of said arithmetic or almost-arithmetic decoder, said state of said model of said decoder comprising: a value of a low limit ($lowU_n$) of a first segment of an interval defined by the reception of a sequence of n second binary elements, a value of an upper limit ($upU_n$) of said first segment, a value of a low limit ($lowS_{Kn}$) of a second segment of said interval obtained when a sequence of x-ary symbols is determined from said n second binary elements, a value of an upper limit ($upS_{Kn}$) of said second interval and a counter ($K_n$) representing the number of determined x-ary symbols associated with said n second binary elements received.

4.  Method according to claim 1, **characterised in that** it comprises a determination step of a stream of m-ary symbols from the stream of determined x-ary symbols,
    m being greater than or equal to x and the source model comprising transitions associated with a correspondence between source m-ary symbols ($A_k$) and target x-ary symbols ($S_k$).

5.  Method according to one of the aforementioned claims, **characterised in that** the product and coder or decoder models are of arithmetic type.

6.  Method according to one of the aforementioned claims, **characterised in that** step a. comprises the calculations, by steps, of decoder products an x-ary symbol knowing stream bits of second binary elements.

7.  Method according to claim 6, **characterised in that** step a. comprises the generation of a tree constituted by states linked by transitions, each state corresponding to a probability calculation step and each transition, to the start of a state, corresponding to one of these calculated probabilities.

8.  Method according to claims 1 and 7, **characterised in that** step b. comprises the calculation of the product of the probabilities corresponding to successive transitions in the tree and the selection of the largest product corresponding to the most probable successive transitions and to the most probable stream of x-ary symbols.

**9.** Method according to claims 6 and 8, **characterised in that** step a. comprises the calculation, for a given number of successive x-ary symbols to decode, of the probabilities of decoding a sequence of x-ary symbols knowing bits from the stream of second binary elements.

**10.** Method according to claims 6 and 8, **characterised in that** step a. comprises the calculation, for a given number of successive bits of the stream of second binary elements, of the probabilities of decoding a sequence of x-ary symbols knowing bits from the stream of second binary elements.

**11.** Method according to one of claims 1 to 5, **characterised in that** from the product model establishing said correspondence, step a. comprises

c1. the successive construction of states linked by transitions of a diagram of states produced from an original state to a final state, each state defining an expected number of x-ary symbols decoded for a given number of bits of the stream of second binary elements from the original state.

**12.** Method according to claim 11, **characterised in that** the construction of step a. comprises

c2. the successive deletion of states of the diagram of states produced, from the final state to the original state, for which the expected number of x-ary symbols for a given number of bits of the stream of second binary elements is different from a maximum known number of x-ary symbols.

**13.** Method according to one of claims 11 to 12, **characterised in that** step a. comprises

c1. the calculation, after each state constructed, of the first successive probabilities to result in a given state knowing past bits of the stream of second binary elements,
c2. the calculation, for each state from the final state to the original state, of the second successive probabilities to observe the next bits of the stream of second binary elements knowing this given state.

**14.** Method according to one of claims 11 to 12, **characterised in that** step a. comprises

c3. the calculation, for each state of the diagram from the original state to the final state, of the first successive probabilities to result in this given state knowing the past bits of the stream of second binary elements, and, for each state from the final state to the original state, of the second successive probabilities to observe the next bits of the stream of second binary elements knowing a given status.

**15.** Method according to one of claims 11 to 14, **characterised in that** step a. comprises the calculation of the probability to result in this given state knowing the bits of the stream of second binary elements by obtaining the product of the first and second probabilities for each state.

**16.** Method according to claims 1 and 15, **characterised in that** step b. comprises the calculation of the products of probabilities of the different successive states possible then the selection of the maximum product.

**17.** Method according to claims 11 and 16, **characterised in that**, the correspondence defined by the product model being established in the form of a table, the step b. comprises the establishment of the stream of x-ary symbols corresponding to these successive states by reading said table.

**18.** Arithmetic or almost-arithmetic decoding device of binary elements received from a channel in x-ary symbols comprising,
means for receiving from said channel a stream of N second binary elements $Y_i$ corresponding to N first binary elements $U_i$ transmitted, by means of said channel, from an arithmetic or almost-arithmetic coder to said decoder with i between 1 and N, said coder coding a source of symbols;
means for decoding said N second binary elements $Y_i$ into a stream of K x-ary symbols $S_j$ with j between 1 and K;
**characterised in that** it comprises means for calculating probabilities of resulting in product states knowing bits of the stream of second binary elements Y, from a model of said channel,
from a model of said source and
from a product model defining a correspondence between said x-ary symbols $S_j$ and said first binary elements $U_i$, according to product states in
a diagram of 'product' states, a product state comprising a source state and a state of a model of said coder or said arithmetic or almost-arithmetic decoder, and
means to determine the most probable stream of x-ary symbols from calculated probabilities.

19. Device according to claim 18, **characterised in that** each product state comprises a source state (Ck) and a state of said model of said arithmetic or almost-arithmetic coder, said coder model state comprising: a low limit value ($lowS_k$) of an interval resulting from successive subdivisions of an interval corresponding to the coding of a sequence of k x-ary symbols, an upper limit value of said interval ($upS_k$) and a counter ($N_k$) representing the number of first binary elements associated with the k first x-ary symbols.

20. Device according to claim 18, **characterised in that** said product state comprises a source state and a state of said model of said arithmetic or almost-arithmetic decoder, said state of said model of said decoder comprising: a value of a low limit ($lowU_n$) of a first segment of an interval defined by the reception of a sequence of n second binary elements, a value of an upper limit ($upU_n$) of said first segment, a value of a low limit ($lowSK_n$) of a second segment of said interval obtained when a sequence of x-ary symbols is determined from said n second binary elements, a value of an upper limit ($upS_{Kn}$) of said second interval and a counter ($K_n$) representing the number of determined x-ary symbols associated with said n second binary elements received.

FIG.1

EP 1 527 521 B1

EP 1 527 521 B1

Fréquence, tailles
et valeurs

```
                                    ┌──────────────┐
  100                               │ Insertion de │
Source      ╱Marqueurs╲    oui      │  marqueurs   │──102
──────────▶◀  m-aires ? ▶─────────▶│   m-aires    │
m-aire+     ╲         ╱             └──────────────┘
modèle          │ non
```

Fréquence, tailles
et valeurs

```
          ┌───────────┐                    ┌──────────────┐
 ╱        ╲│ Conversion│ Source  ╱Marqueurs╲  oui │Insertion de │
◀Conversion?▶──▶│m-aire vers│──────▶◀ binaires? ▶─────▶│ marqueurs  │
 ╲        ╱ oui │  binaire  │binaire+ ╲        ╱        │  binaires  │
     │ non      └───────────┘modèle       │ non        └────────────┘
    104            106          108                        110
```

FIG.2

```
                              T     112
                          ┌──────────┐
                          │ Codage   │  Train
                          │ quasi-   │─────────▶
                          │arithmétique│ binaire
                          └──────────┘
```

FIG.3

FIG.4a

FIG.4b

FIG.4c

FIG.5a

FIG.5b

|  |  | | C1 | | C2 modèle d'états normal, | | | | C3 modèle d'états simplifié, | | | |
|---|---|---|---|---|---|---|---|---|---|---|---|---|
| état $E_k$ | $[lowS_k, upS_k[$ | P(0), subdivision d'intervalle correspondante | | | $S_k=0$ bits émis | $S_k=0$ état suiv. | $S_k=1$ bits émis | $S_k=1$ état suiv. | $S_k=MPS$ bits émis | $S_k=MPS$ état suiv. | $S_k=LPS$ bits émis | $S_k=LPS$ état suiv. |
| 0 | [0,4[ | $0.63 \leq P(0)$ | [0,3[ | | - | 1 | 11 | 0 | - | 1 | 11 | 0 |
|  |  | $0.37 \leq P(0) < 0.63$ | [0,2[ | | 0 | 0 | 1 | 0 | 0 | 0 | 1 | 0 |
|  |  | $P(0) < 0.37$ | [0,1[ | | 00 | 0 | - | 2 |  |  |  |  |
| 1 | 0,3 | $0.5 \leq P(0)$ | [0,2[ | | 0 | 0 | 10 | 0 | 0 | 0 | 10 | 0 |
|  |  | $P(0) < 0.5$ | [0,1[ | | 00 | 0 | f | 0 |  |  |  |  |
| 2 | [1,4[ | $0.5 \leq P(0)$ | [1,3[ | | f | 0 | 11 | 0 |  |  |  |  |
|  |  | $P(0) < 0.5$ | [1,2[ | | 01 | 0 | 1 | 0 |  |  |  |  |

**Table 1**

| état $E_n$ | K1 variables d'état | K1 P(MPS) (subdivision de $[lowS_{k_n}, upS_{k_n}[$ correspondante) | K2 $U_n=0$ symb. émis | K2 $U_n=0$ état suiv. | K3 $U_n=1$ symb. émis | K3 $U_n=1$ état suiv. |
|---|---|---|---|---|---|---|
| 0 | $[lowU_n, upU_n[ : [0,4[$ | $0.63 \leq P(MPS)$ ([0,3[) | MPS, MPS | 0 | - | 1 |
|  | $[lowS_{k_n}, upS_{k_n}[ : [0,4[$ | $0.37 < P(MPS) < 0.63$ ([0,2[) | MPS | 0 | LPS | 0 |
| 1 | $[lowU_n, upU_n[ : [2,4[$ $[lowS_{k_n}, upS_{k_n}[ : [0,4[$ | $0.63 \leq P(MPS)$ ([0,3[) | MPS, LPS | 0 | LPS | 0 |

**Table 2**

| état $X_k$ | variables d'état | MPS | LPS |
|---|---|---|---|
| 0 état initial | [0,4[ C=0 | bits émis : 0 état suiv. : 1 | bits émis : 1 état suiv. : 2 |
| 1 | [0,4[ C=1 | bits émis : – état suiv. : 3 | bits émis : 11 état suiv. : 0 |
| 2 | [0,4[ C=2 | bits émis : – état suiv. : 3 | bits émis : 11 état suiv. : 0 |
| 3 | [0,3[ C=0 | bits émis : 0 état suiv. : 1 | bits émis : 0 état suiv. : 2 |

FIG.6A

FIG.6B

FIG.7A

FIG.7B

FIG.8

| état $X_k$ | variables d'état | $U_n = 0$ | $U_n = 1$ |
|---|---|---|---|
| 0 état initial | $[0,4[$ $[0,4[$ $C=0$ | symb. émis : MPS état suiv. : 1 | symb. émis : LPS état suiv. : 2 |
| 1 | $[0,4[$ $[0,4[$ $C=1$ | symb. émis : MPS,MPS état suiv. : 1 | symb. émis : – état suiv. : 3 |
| 2 | $[0,4[$ $[0,4[$ $C=2$ | symb. émis : MPS,MPS état suiv. : 1 | symb. émis : – état suiv. : 4 |
| 3 | $[2,4[$ $[0,4[$ $C=1$ | symb. émis : MPS,LPS état suiv. : 2 | symb. émis : LPS état suiv. : 0 |
| 4 | $[2,4[$ $[0,4[$ $C=2$ | symb. émis : MPS,LPS état suiv. : 2 | symb. émis : LPS état suiv. : 0 |

FIG.9a

FIG.9b

FIG.10

FIG.11

Modèle de
source, K, N

Construction
du treillis
d'estimation

Passe avant: ─400
construction

Treillis surchargé

Passe arrière: ─402
simplification

Treillis

BCJR Adapté

Passe
avant $P(X_n, K_n | Y_1^n)$ ─408

$P(U_n | Y_n)$ ─404

─406

Passe
arrière $P(X_n, K_n | Y_{n+1}^N)$

Produit $P(X_n, K_n | Y)$

─410

Produit

$P(X, K | Y)$

412─

Sélection du chemin
le plus vraisemblable
(max $P(X, K | Y)$ ),
lecture de la séquence de
symboles correspondante
dans la table mémorisant
le modèle produit

$\hat{S}$

FIG.12

FIG.13

FIG.14

FIG.15

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 4286256 A
- US 4467317 A
- US 4652856 A

**Littérature non-brevet citée dans la description**

- Joint source-channel turbo decoding of VLC-coded Markovsources. **FABRE et al.** IEEE INTERNATIONAL CONFERENCE ON ACOUSTICS, SPEECH, AND SIGNAL PROCESSING. PROCEEDINGS (CAT. NO.01CH37221), 2001 IEEE INTERNATIONAL CONFERENCE ON ACOUSTICS, SPEECH, AND SIGNAL PROCESSING. PROCEEDINGS, SALT LAKE CITY, UT, USA. IEEE, 2001, vol. 4, 2657-2660
- **D.A. HUFFMAN.** A method for the construction of minimum redundancy codes. *Proc. IRE,* 1951, vol. 40, 1098-1101
- **J.J. RISSANEN.** Generalized kraft inequality and arithmetic. *IBM J.Res. Develop.,* Mai 1976, vol. 20, 198-203
- **J.J. RISSANEN.** Arithmetic Coding as number representations. *Acta Polytech. Scand. Math.,* Décembre 1979, vol. 31, 44-51
- **I.H. WITTEN ; R. M. NEAL ; J. G. CLEARY.** *Arithmetic coding for data compression. Communications of the ACM,* Juin 1987, vol. 30 (6), 520-540
- **P. G. HOWARD ; J. S. VITTER.** Image and Text Compression. Kluwer Academic Publisher, 1992, 85-112
- **P. G. HOWARD ; J. S. VITTER.** Design and analysis of fast text compression based on quasi-arithmetic coding. *In Data Compression Conference,* Mars 1993, 98-107
- **L.R. BAHL ; J. COCKE ; F. JELINEK ; J.RAVIV.** Optimal decoding of linear codes for minimizing symbol error rate. *IEEE trans. on information theory,* Mars 1974, vol. 02, 284-287